# EUROPEAN PATENT APPLICATION

(11) **EP 1 718 124 A1**
(43) Date of publication of application: **02.11.2006**
(21) Application number: 05719244.5
(22) Date of filing: 17.02.2005
(51) Int. Cl.: H05B 33/14, C09K 11/06

(54) **WHITE COLOR ORGANIC ELECTROLUMINESCENCE DEVICE**

(30) Priority: 19.02.2004 JP 2004042694
(71) Applicant: IDEMITSU KOSAN CO., LTD., Tokyo 100-8321 (JP)
(72) Inventor: TOKAIRIN, Hiroshi, 2990293 (JP); FUKUOKA, Kenichi, 2990293 (JP); KUBOTA, Mineyuki, 2990293 (JP); FUNAHASHI, Masakazu, 2990293 (JP)
(74) Representative: Gille Hrabal Struck Neidlein Prop Roos
(86) International application number: PCT/JP2005/002442
(87) International publication number: WO 2005/081587

(57) **Abstract**

The present invention provides a white color organic electroluminescence device including: a cathode; an anode; and one or more organic thin film layers including at least a light emitting layer, the one or more organic thin film layers being sandwiched between the cathode and the anode, in which the light emitting layer is constituted of a laminate of a bluish color light emitting layer and a yellow-to-reddish color light emitting layer, and the light emitting layer contains an asymmetric compound containing a condensed ring. This white color organic EL device realizes reduced chromaticity changes, excels in efficiency of light emission and thermal stability, and ensures strikingly prolonged lifetime.

## Description

### TECHNICAL FIELD

The present invention relates to a white color organic electroluminescence (EL) device. In particular, the present invention relates to a white color organic electroluminescence device that realizes reduced chromaticity changes, excels in efficiency of light emission and thermal stability, and ensures strikingly prolonged lifetime.

### BACKGROUND ART

In recent years, organic EL devices for display devices have been vigorously developed. In particular, a white color organic EL device has been actively developed because it can be used in applications including a mono-color display device, a light source such as a backlight, and a full-color display device using a color filter.
A large number of methods of obtaining white light emission by means of an organic EL have been disclosed. In few of those methods, a white color is obtained by means of only one kind of light emitting material. In most of those methods, two or three kinds of light emitting materials cause to simultaneously emit light in one organic EL. In the case where three kinds of light emitting materials are used, red light emission, blue light emission, and green light emission (red, blue, and green correspond to the three primary colors of light) are combined to provide a white color. However, this case involves a problem in that chromaticity is hardly controlled and hence repeatability is poor. In the case where two kinds of light emitting materials are used, a bluish color light emitting material and a yellow-to-reddish color light emitting material (a yellow-to-reddish color is a complementary color for a bluish color) are selected. In this case, however, yellow-to-reddish light emission often becomes strong, so a chromaticity change is apt to occur. As described in, for example, Reference Examples 1 and 2 of Patent Document 1 below, a conventional white color organic EL is apt to cause a reduction in blue light emission, so it presents problems in terms of chromaticity changes. White light emission can be obtained also by doping a bluish color dopant and a yellow-to-reddish color dopant at the same time and adjusting a dope ratio. In this case, however, red is apt to be strong. In addition, energy transfer fromblue to red is apt to occur. Therefore, a reddish white color is apt to render. Accordingly, a yellow-to-reddish color dopant must be doped at an extremely low concentration for obtaining a white color, so that a problem arises in that repeatability is hardly achieved. Furthermore, a lamination type in which a yellow-to-reddish color light emitting layer is used as a anode side light emitting layer and a bluish color light emitting layer is used as a cathode side light emitting layer is categorized into a type in which a light emitting layer is divided into two sections. In this case, excellent efficiency of light emission can be obtained. However, the thickness of the yellow-to-reddish color light emitting layer must be smaller than that of the bluish color light emitting layer or the dope concentration of the yellow-to-reddish color light emitting layer must be lower than that of the bluish color light emitting layer in order to suppress yellow-to-reddish light emission for obtaining a white color. Such requirement complicates device fabrication. Specifically, in many cases, white light emission cannot be obtained unless the thickness of the yellow-to-reddish color light emitting layer is about 1 to 2 nm. It can be said that the thickness of the layer is extremely hardly controlled to the value because the thickness is a thickness comparable to the molecular size of a typical low-molecular-weight organic EL.
To solve those problems, Patent Document 2 below discloses a white color organic EL device of a type in which a light emitting layer is divided into two sections, the white color organic EL device eliminating a tendency in that a luminescent color is apt to lean to red by using a bluish color light emitting layer as a anode side light emitting layer whose light emitting domain is apt to lean.
However, when one attempts to apply the white color organic EL device to various display instruments such as a full-color display and a display to be mounted on a vehicle, the luminance stability of the device upon continuous driving, that is, the lifetime of the device is not always sufficient.
Patent Document 1: JP-A-2001-52870
Patent Document 2: JP-A-2003-272857

### DISCLOSURE OF THE INVENTION

The present invention has been made with a view to solving the above problems, and an object of the present invention is to provide a white color organic EL device that realizes reduced chromaticity changes, excels in efficiency of light emission and thermal stability, and ensures strikingly prolonged lifetime.

The inventors of the present invention have made extensive studies to achieve the above object. As a result, they have found that the lifetime of a white color organic EL device can be significantly prolonged by constituting a light emitting layer by means of a laminate of a bluish color light emitting layer and a yellow-to-reddish color light emitting layer and incorporating an asymmetric compound containing a condensed ring into the light emitting layer upon production of the device, thereby completing the present invention.
That is, according to the present invention, there is provided a white color organic EL device comprising: a cathode; an anode; one or more organic thin film layers sandwiched between the two electrodes and including at least a light emitting layer, wherein the light emitting layer has a laminate comprising a bluish color light emitting layer and a yellow-to-reddish color light emitting layer; and the light emitting layer comprises an asymmetric compound containing a condensed ring.

The white color organic EL device of the present invention realizes reduced chromaticity changes, excels in efficiency of light emission and thermal stability, and ensures strikingly prolonged lifetime, so it has high practicability.

### BEST MODE FOR CARRYING OUT THE INVENTION

The white color organic EL device of the present invention comprises: a cathode; an anode; one or more organic thin film layers sandwiched between the two electrodes and including at least a light emitting layer, wherein the light emitting layer has a laminate comprising a bluish color light emitting layer and a yellow-to-reddish color light emitting layer; and the light emitting layer comprises an asymmetric compound containing a condensed ring.

Examples of the layer constitution of the white color organic EL device of the present invention include the following.
(1) An anode/a bluish color light emitting layer/a yellow-to-reddish color light emitting layer/a cathode
(2) A anode/a hole transporting layer/a bluish color light emitting layer/a yellow-to-reddish color light emitting layer/a cathode
(3) An anode/a bluish color light emitting layer/a yellow-to-reddish color light emitting layer/an electron transporting layer/a cathode
(4) An anode/a hole transporting layer/a bluish color light emitting layer/a yellow-to-reddish color light emitting layer/an electron transporting layer/a cathode
(5) A anode/a hole injecting layer/a hole transporting layer/a bluish color light emitting layer/a yellow-to-reddish color light emitting layer/an electron transporting layer/a cathode
(6) A anode/a hole transporting layer/a bluish color light emitting layer/a yellow-to-reddish color light emitting layer/an electron transporting layer/an electron injecting layer/a cathode
(7) A anode/a hole injecting layer/a hole transporting layer/a bluish color light emitting layer/a yellow-to-reddish color light emitting layer/an electron transporting layer/an electron injecting layer/a cathode
(8) An anode/a yellow-to-reddish color light emittinglayer/a bluish color light emitting layer/a cathode
(9) An anode/a hole transporting layer/a yellow-to-reddish color light emitting layer/a bluish color light emitting layer/a cathode
(10) An anode/a yellow-to-reddish color light emitting layer/a bluish color light emitting layer/an electron transporting layer/a cathode
(11) An anode/a hole transporting layer/a yellow-to-reddish color light emitting layer/a bluish color light emitting layer/an electron transporting layer/a cathode
(12) An anode/a hole injecting layer/a hole transporting layer/a yellow-to-reddish color light emitting layer/a bluish color light emitting layer/an electron transporting layer/a cathode
(13) An anode/a hole transporting layer/a yellow-to-reddish color light emitting layer/a bluish color light emitting layer/an electron transporting layer/an electron injecting layer/a cathode
(14) An anode/a hole injecting layer/a hole transporting layer/a yellow-to-reddish color light emitting layer/a bluish color light emitting layer/an electron transporting layer/an electron injecting layer/a cathode

As described above, the white color organic EL device of the present invention has only to be of a structure in which the light emitting layer is divided into two sections: the bluish color light emitting layer and the yellow-to-reddish color light emitting layer. For example, the device may be of a multilayer structure in which each of the bluish color light emitting layer and the yellow-to-reddish color light emitting layer is composed of two or more layers. However, the light emitting layer preferably consists of two layers: the bluish color light emitting layer and the yellow-to-reddish color light emitting layer.
In addition, the white color organic EL device of the present invention preferably has the layer constitution of any one of the forgoing terms (1) to (7) in which the bluish color light emitting layer is laminated on a anode side and the yellow-to-reddish color light emitting layer is laminated on a cathode side.
Each of the bluish color light emitting layer and the yellow-to-reddish color light emitting layer preferably has a thickness of 5 nm or more. The thickness of the bluish color light emitting layer is more preferably 5 to 30 nm, particularly preferably 7 to 30 nm, or most preferably 10 to 30 nm. As long as the thickness of the bluish color light emitting layer is 5 nm or more, neither the formation of the light emitting layer nor the adjustment of chromaticity becomes difficult. In addition, as long as the thickness is 30 nm or less, a driving voltage does not increase. In addition, the thickness of the yellow-to-reddish color light emitting layer is more preferably 10 to 50 nm, particularly preferably 20 to 50 nm, or most preferably 30 to 50 nm. As long as the thickness of the yellow-to-reddish color light emitting layer is 5 nm or more, efficiency of light emission does not reduce. In addition, as long as the thickness is 50 nm or less, there is no possibility that a driving voltage increases.

In the white color organic EL device of the present invention, the bluish color light emitting layer is preferably composed of a bluish color host material and a bluish color dopant, and the bluish color host material is preferably composed of an asymmetric compound containing a condensed ring although the bluish color host material and the bluish color dopant are not particularly limited.
Representative examples of the asymmetric compound containing a condensed ring include an asymmetric anthracene-based compound and an asymmetric pyrene-based compound.
Hereinafter, the asymmetric anthracene-based compound to be used in the present invention will be described.
The asymmetric anthracene-based compound is preferably a compound represented by the following general formula (I).

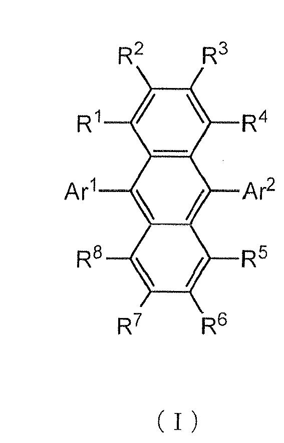

In the general formula (I), Ar¹ and Ar² each independently represent a substituted or unsubstituted aryl group having 6 to 50 nuclear carbon atoms, provided that Ar¹ and Ar² do not have the same structure; and
R¹ to R⁸ each independently represent a hydrogen atom, a substituted or unsubstituted aryl group having 6 to 50 nuclear carbon atoms, a substituted or unsubstituted aromatic heterocyclic group having 5 to 50 nuclear atoms, a substituted or unsubstituted alkyl group having 1 to 50 carbon atoms, a substituted or unsubstituted alkoxy group having 1 to 50 carbon atoms, a substituted or unsubstituted aralkyl group having 6 to 50 carbon atoms, a substituted or unsubstituted aryloxy group having 5 to 50 nuclear atoms, a substituted or unsubstituted arylthio group having 5 to 50 nuclear atoms, a substituted or unsubstituted alkoxycarbonyl group having 1 to 50 carbon atoms, a carboxyl group, a halogen atom, a cyano group, a nitro group, or a hydroxyl group.

Examples of the aryl group represented by each of Ar¹ and Ar² in the general formula (I) include a phenyl group, a 1-naphthyl group, a 2-naphthyl group, a 1-anthryl group, a 2-anthryl group, a 9-anthryl group, a 1-phenanthryl group, a 2-phenanthryl group, a 3-phenanthrylgroup, a 4-phenanthryl group, a 9-phenanthryl group, a 1-naphthacenyl group, a 2-naphthacenyl group, a 9-naphthacenyl group, a 1-pyrenyl group, a 2-pyrenyl group, a 4-pyrenyl group, a 2-biphenylyl group, a 3-biphenylyl group, a 4-biphenylyl group, a p-terphenyl-4-yl group, a p-terphenyl-3-yl group, a p-terphenyl-2-yl group, an m-terphenyl-4-yl group, an m-terphenyl-3-ylgroup, anm-terphenyl-2-yl group, ano-tolylgroup, an m-tolyl group, a p-tolyl group, a p-t-butylphenyl group, a p-(2-phenylpropyl)phenyl group, a 3-methyl-2-naphthyl group, a 4-methyl-1-naphthyl group, a 4-methyl-1-anthryl group, a 4'-methylbiphenylyl group, and a 4"-t-butyl-p-terphenyl-4-yl group.

Examples of the aryl group represented by each of R¹ to R⁸ in the general formula (I) include the same groups as those of Ar¹ and Ar².
Examples of the aromatic heterocyclic group represented by each of R¹ to R⁸ in the general formula (I) include a 1-pyrolyl group, a 2-pyrolyl group, a 3-pyrolyl group, a pyradinyl group, a 2-pyridinyl group, a 3-pyridinyl group, a 4-pyridinyl group, a 1-indolyl group, a 2-indolyl group, a 3-indolyl group, a 4-indolyl group, a 5-indolyl group, a 6-indolyl group, a 7-indolyl group, a 1-isoindolyl group, a 2-isoindolyl group, a 3-isoindolyl group, a 4-isoindolyl group, a 5-isoindolyl group, a 6-isoindolyl group, a 7-isoindolyl group, a 2-furyl group, a 3-furyl group, a 2-benzofuranyl group, a 3-benzofuranyl group, a 4-benzofuranylgroup, a 5-benzofuranyl group, a 6-benzofuranyl group, a 7-benzofuranyl group, a 1-isobenzofuranyl group, a 3-isobenzofuranyl group, a 4-isobenzofuranyl group, a 5-isobenzofuranyl group, a 6-isobenzofuranyl group, a 7-isobenzofuranyl group, a quinolyl group, a 3-quinolyl group, a 4-quinolyl group, a 5-quinolyl group, a 6-quinolyl group, a 7-quinolyl group, an 8-quinolyl group, a 1-isoquinolyl group, a 3-isoquinolyl group, a 4-isoquinolyl group, a 5-isoquinolyl group, a 6-isoquinolyl group, a 7-isoquinolyl group, an 8-isoquinolyl group, a 2-quinoxalinyl group, a 5-quinoxalinyl group, a 6-quinoxalinyl group, a 1-carbazolyl group, a 2-carbazolyl group, a 3-carbazolyl group, a 4-carbazolyl group, a 9-carbazolyl group, a 1-phenanthridinyl group, a 2-phenanthridinyl group, a 3-phenanthridinyl group, a 4-phenanthridinyl group, a 6-phenanthridinyl group, a 7-phenanthridinyl group, an 8-phenanthridinyl group, a 9-phenanthridinyl group, a 10-phenanthridinylgroup, a 1-acridinyl group, a 2-acridinyl group, a 3-acridinyl group, a 4-acridinyl group, a 9-acridinyl group, a 1,7-phenanthrolin-2-yl group, a 1,7-phenanthrolin-3-yl group, a 1,7-phenanthrolin-4-yl group, a 1,7-phenanthrolin-5-yl group, a 1,7-phenanthrolin-6-yl group, a 1,7-phenanthrolin-8-yl group, a 1,7-phenanthrolin-9-yl group, a 1,7-phenanthrolin-10-yl group, a 1,8-phenanthrolin-2-yl group, a 1,8-phenanthrolin-3-yl group, a 1,8-phenanthrolin-4-yl group, a 1,8-phenanthrolin-5-yl group, a 1,8-phenanthrolin-6-yl group, a 1,8-phenanthrolin-7-yl group, a 1,8-phenanthrolin-9-yl group, a 1,8-phenanthrolin-10-yl group, a 1,9-phenanthrolin-2-yl group, a 1,9-phenanthrolin-3-yl group, a 1,9-phenanthrolin-4-yl group, a 1,9-phenanthrolin-5-yl group, a 1,9-phenanthrolin-6-yl group, a 1,9-phenanthrolin-7-yl group, a 1,9-phenanthrolin-8-yl group, a 1,9-phenanthrolin-10-yl group, a 1,10-phenanthrolin-2-yl group, a 1,10-phenanthrolin-3-yl group, a 1,10-phenanthrolin-4-yl group, a 1,10-phenanthrolin-5-yl group, a 2,9-phenanthrolin-1-yl group, a 2,9-phenanthrolin-3-yl group, a 2,9-phenanthrolin-4-yl group, a 2,9-phenanthrolin-5-yl group, a 2,9-phenanthrolin-6-yl group, a 2,9-phenanthrolin-7-yl group, a 2,9-phenanthrolin-8-yl group, a 2,9-phenanthrolin-10-yl group, a 2,8-phenanthrolin-1-yl group, a 2,8-phenanthrolin-3-yl group, a 2,8-phenanthrolin-4-yl group, a 2,8-phenanthrolin-5-yl group, a 2,8-phenanthrolin-6-yl group, a 2,8-phenanthrolin-7-yl group, a 2,8-phenanthrolin-9-yl group, a 2,8-phenanthrolin-10-yl group, a 2,7-phenanthrolin-1-yl group, a 2,7-phenanthrolin-3-yl group, a 2,7-phenanthrolin-4-yl group, a 2,7-phenanthrolin-5-yl group, a 2,7-phenanthrolin-6-yl group, a 2,7-phenanthrolin-8-yl group, a 2,7-phenanthrolin-9-yl group, a 2,7-phenanthrolin-10-yl group, a 1-phenadinyl group, a 2-phenadinyl group, a 1-phenothiadinyl group, a 2-phenothiadinyl group, a 3-phenothiadinyl group, a 4-phenothiadinylgroup, a 10-phenothiadinyl group, a 1-phenoxadinyl group, a 2-phenoxadinyl group, a 3-phenoxadinyl group, a 4-phenoxadinyl group, a 10-phenoxadinyl group, a 2-oxazolyl group, a 4-oxazolyl group, a 5-oxazolyl group, a 2-oxadiazolyl group, a 5-oxadiazolyl group, a 3-furazanyl group, a 2-thienyl group, a 3-thienyl group, a 2-methylpyrrol-1-yl group, a 2-methylpyrrol-3-yl group, a 2-methylpyrrol-4-yl group, a 2-methylpyrrol-5-yl group, a 3-methylpyrrol-1-yl group, a 3-methylpyrrol-2-yl group, a 3-methylpyrrol-4-yl group, a 3-methylpyrrol-5-yl group, a 2-t-butylpyrrol-4-yl group, a 3-(2-phenylpropyl)pyrrol-1-yl group, a 2-methyl-1-indolyl group, a 4-methyl-1-indolyl group, a 2-methyl-3-indolyl group, a 4-methyl-3-indolyl group, a 2-t-butyl 1-indolyl group, a 4-t-butyl 1-indolyl group, a 2-t-butyl 3-indolyl group, and a 4-t-butyl 3-indolyl group.

Examples of the alkyl group represented by each of R¹ to R⁸ in the general formula (I) include a methyl group, an ethyl group, a propyl group, an isopropyl group, an n-butyl group, an s-butyl group, an isobutyl group, a t-butyl group, an n-pentyl group, an n-hexyl group, an n-heptyl group, an n-octyl group, a hydroxymethyl group, a 1-hydroxyethyl group, a 2-hydroxyethyl group, a 2-hydroxyisobutyl group, a 1,2-dihydroxyethyl group, a 1,3-dihydroxyisopropyl group, a 2,3-dihydroxy-t-butyl group, a 1,2,3-trihydroxypropylgroup, a chloromethyl group, a1-chloroethyl group, a 2-chloroethyl group, a 2-chloroisobutyl group, a 1,2-dichloroethyl group, a 1,3-dichloroisopropyl group, a 2,3-dichloro-t-butyl group, a 1,2,3-trichloropropyl group, a bromomethyl group, a 1-bromoethyl group, a 2-bromoethyl group, a 2-bromoisobutyl group, a 1,2-dibromoethyl group, a 1,3-dibromoisopropyl group, a 2,3-dibromo-t-butyl group, a 1, 2, 3-tribromopropyl group, an iodomethyl group, a 1-iodoethyl group, a 2-iodoethyl group, a 2-iodoisobutylgroup, a 1,2-diiodoethylgroup, a 1,3-diiodoisopropyl group, a 2,3-diiodo-t-butyl group, a 1,2,3-triiodopropyl group, an aminomethyl group, a 1-aminoethyl group, a 2-aminoethyl group, a 2-aminoisobutyl group, a 1,2-diaminoethyl group, a 1,3-diaminoisopropyl group, a 2,3-diamino-t-butyl group, a 1,2,3-triaminopropyl group, a cyanomethyl group, a 1-cyanoethyl group, a 2-cyanoethyl group, a 2-cyanoisobutyl group, a 1,2-dicyanoethyl group, a 1,3-dicyanoisopropyl group, a 2,3-dicyano-t-butyl group, a 1,2,3-tricyanopropyl group, a nitromethyl group, a 1-nitroethyl group, a 2-nitroethyl group, a 2-nitroisobutyl group, a 1,2-dinitroethyl group, a 1,3-dinitroisopropyl group, a 2,3-dinitro-t-butyl group, a 1,2,3-trinitropropyl group, a cyclopropyl group, a cyclobutyl group, a cyclopentyl group, a cyclohexyl group, a 4-methylcyclohexyl group, a 1-adamantyl group, a 2-adamantyl group, a 1-norbornyl group, and a 2-norbornyl group.

The alkoxy group represented by each of R¹ to R⁸ in the general formula (I) is represented as -O**Y**, and examples of **Y** include the same groups as those of the alkyl group.
An example of the aralkyl group represented by each of R¹ to R⁸ in the general formula (I) includes the alkyl group substituted by the aryl group.
The aryloxy group represented by each of R¹ to R⁸ in the general formula (I) is represented as -OY', and examples of Y' include the same groups as those of the aryl group.
The arylthio group represented by each of R¹ to R⁸ in the general formula (I) is represented as -OY', and examples of Y' include the same groups as those of the aryl group.
The alkoxycarbonyl group represented by each of R¹ to R⁸ in the general formula (I) is represented as -COO**Y**, and examples of **Y** include the same groups as those of the alkyl group.
Examples of the halogen atom include fluorine, chlorine, bromine, and iodine.

In addition, the asymmetric anthracene-based compound to be used for the white color organic EL device of the present invention is preferably a compound represented by any one of the following general formulae (II) to (IV).

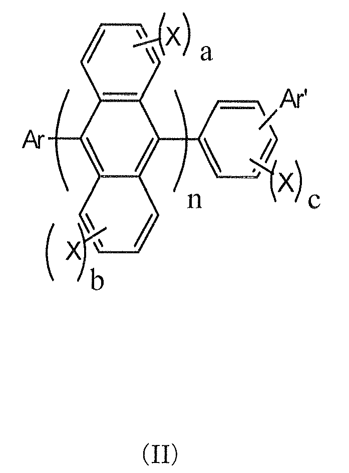

In the general formula (II), Ar represents a substituted or unsubstituted fused aromatic ring residue having 10 to 50 nuclear carbon atoms;
Ar' represents a substituted or unsubstituted aryl group having 6 to 50 nuclear carbon atoms, and the number of Ar's may be two or more;
**X** represents a substituted or unsubstituted aryl group having 6 to 50 nuclear carbon atoms, a substituted or unsubstituted aromatic heterocyclic group having 5 to 50 nuclear atoms, a substituted or unsubstituted alkyl group having 1 to 50 carbon atoms, a substituted or unsubstituted alkoxy group having 1 to 50 carbon atoms, a substituted or unsubstituted aralkyl group having 6 to 50 carbon atoms, a substituted or unsubstituted aryloxy group having 5 to 50 nuclear atoms, a substituted or unsubstituted arylthio group having 5 to 50 nuclear atoms, a substituted or unsubstituted alkoxycarbonyl group having 1 to 50 carbon atoms, a carboxyl group, a halogen atom, a cyano group, a nitro group, or a hydroxyl group; and
**a**, **b**, and **c** each represent an integer of 0 to 4, and **n** represents an integer of 1 to 3.
Examples of the fused aromatic ring residue represented by Ar in the general formula (II) include a 1-naphthyl group, a 2-naphthyl group, a 1-anthryl group, a 2-anthryl group, a9-anthryl group, a1-phenanthryl group, a 2-phenanthryl group, a3-phenanthryl group, a4-phenanthryl group, a 9-phenanthryl group, a1-naphthacenyl group, a2-naphthacenyl group, a 9-naphthacenyl group, a1-pyrenyl group, a2-pyrenyl group, a 4-pyrenyl group, a 3-methyl-2-naphthyl group, a4-methyl-1-naphthyl group, and a 4-methyl-1-anthryl group.
Examples of the aryl group represented by Ar' in the general formula (II) include the same groups as those described above.
Examples of each of the aryl group, the aromatic heterocyclic group, the alkyl group, the alkoxy group, the aralkyl group, the aryloxy group, the arylthio group, and the alkoxycarbonyl group each represented by **X** in the general formula (II) include the same groups as those described above.

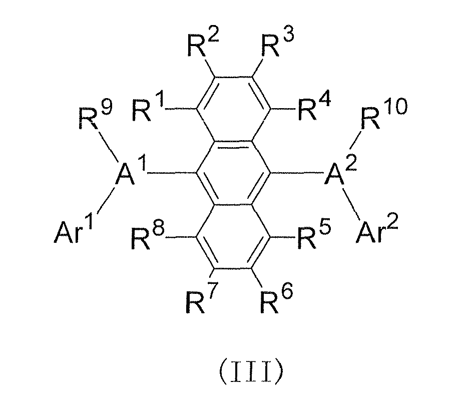

In the general formula (III), A¹ and A² each independently represent a substituted or unsubstituted fused aromatic ring residue having 10 to 20 nuclear carbon atoms;
Ar¹ and Ar² each independently represent a hydrogen atom, or a substituted or unsubstituted aryl group having 6 to 50 nuclear carbon atoms, and each of the number of Ar¹s and the number of Ar²s may be two or more; and
R¹ to R¹⁰ each independently represent a hydrogen atom, a substituted or unsubstituted aryl group having 6 to 50 nuclear carbon atoms, a substituted or unsubstituted aromatic heterocyclic group having 5 to 50 nuclear atoms, a substituted or unsubstituted alkyl group having 1 to 50 carbon atoms, a substituted or unsubstituted alkoxy group having 1 to 50 carbon atoms, a substituted or unsubstituted aralkyl group having 6 to 50 carbon atoms, a substituted or unsubstituted aryloxy group having 5 to 50 nuclear atoms, a substituted or unsubstituted arylthio group having 5 to 50 nuclear atoms, a substituted or unsubstituted alkoxycarbonyl group having 1 to 50 carbon atoms, a carboxyl group, a halogen atom, a cyano group, a nitro group, or a hydroxyl group, and each of the number of R⁹s and the number of R¹⁰s may be two or more, provided that no symmetrical group binds to each of 9-position and 10-position of central anthracene.
Examples of the fused aromatic ring residue represented by each of A¹ and A² in the general formula (III) include those each having a matching valence out of the examples of the fused aromatic ring residue represented by Ar in the general formula (II).
Examples of the aryl group represented by each of Ar¹ and Ar² in the general formula (III) include the same groups as those described above.
Examples of each of the aryl group, the aromatic heterocyclic group, the alkyl group, the alkoxy group, the aralkyl group, the aryloxy group, the arylthio group, and the alkoxycarbonyl group each represented by each of R¹ to R¹⁰ in the general formula (III) include the same groups as those described above.

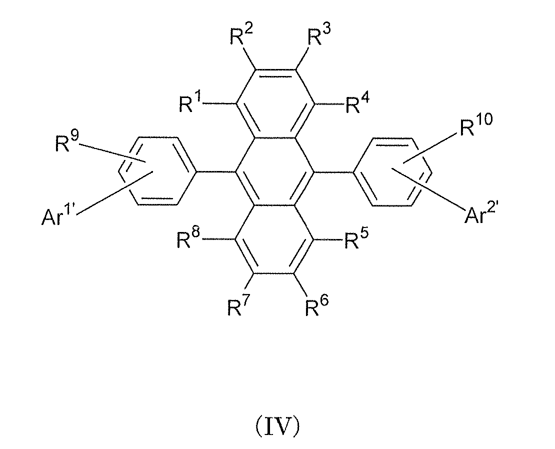

In the general formula (IV), Ar^{1'} and Ar^{2'} each independently represent a substituted or unsubstituted aryl group having 6 to 50 nuclear carbon atoms, and each of the number of Ar¹'s and the number of Ar²'s may be two or more; and
R¹ to R¹⁰ each independently represent a hydrogen atom, a substituted or unsubstituted aryl group having 6 to 50 nuclear carbon atoms, a substituted or unsubstituted aromatic heterocyclic group having 5 to 50 nuclear atoms, a substituted or unsubstituted alkyl group having 1 to 50 carbon atoms, a substituted or unsubstituted alkoxy group having 1 to 50 carbon atoms, a substituted or unsubstituted aralkyl group having 6 to 50 carbon atoms, a substituted or unsubstituted aryloxy group having 5 to 50 nuclear atoms, a substituted or unsubstituted arylthio group having 5 to 50 nuclear atoms, a substituted or unsubstituted alkoxycarbonyl group having 1 to 50 carbon atoms, a carboxyl group, a halogen atom, a cyano group, a nitro group, or a hydroxyl group, and each of the number of R⁹s and the number of R¹⁰s may be two or more, provided that no symmetrical group binds to each of 9-position and 10-position of central anthracene.
Examples of the aryl group represented by each of Ar¹' and Ar²' in the general formula (IV) include the same groups as those described above.
Examples of each of the aryl group, the aromatic heterocyclic group, the alkyl group, the alkoxy group, the aralkyl group, the aryloxy group, the arylthio group, and the alkoxycarbonyl group each represented by each of R¹ to R¹⁰ in the general formula (IV) include the same groups as those described above.
In addition, examples of substituents for the above respective groups include a halogen atom, a hydroxyl group, a nitro group, a cyano group, an alkyl group, an aryl group, a cycloalkyl group, an alkoxy group, an aromatic heterocyclic group, an aralkyl group, an aryloxy group, an arylthio group, an alkoxycarbonyl group, and a carboxyl group.

Specific examples of the asymmetric anthracene-based compound represented by any one of the general formulae (I) to (IV) are shown below. However, the compound is not limited to these exemplified compounds.

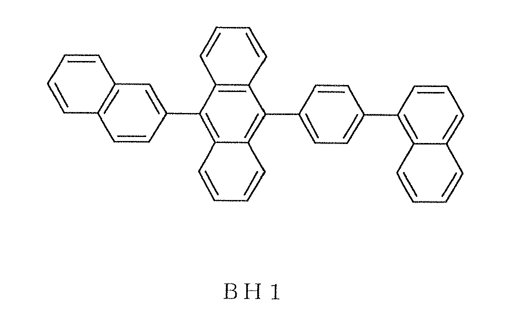

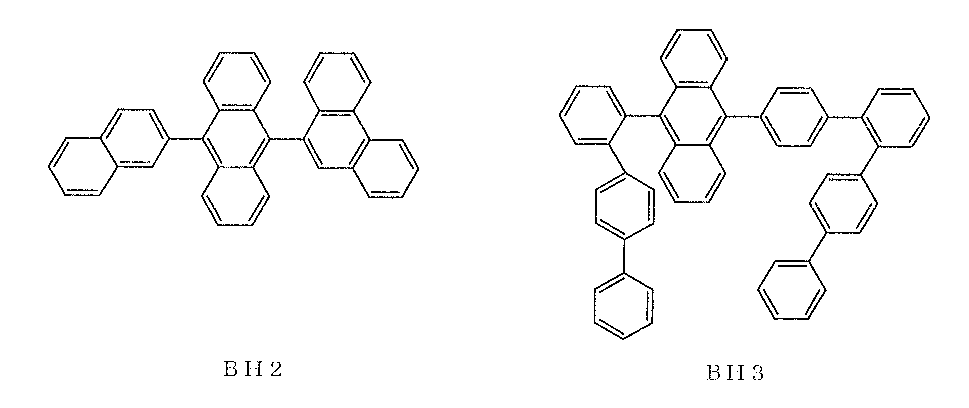

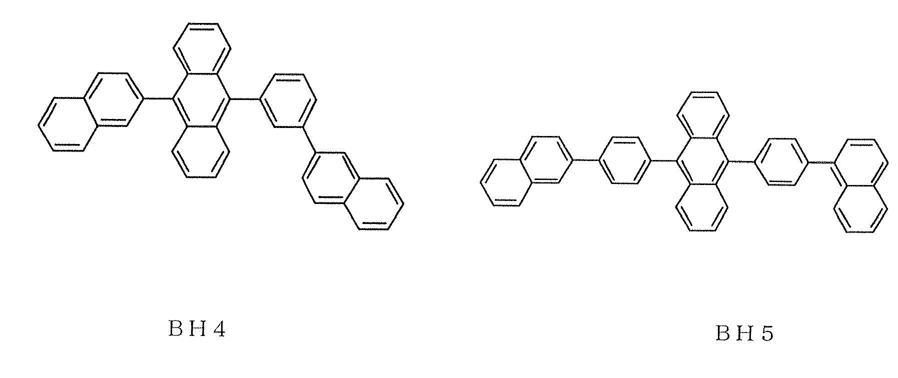

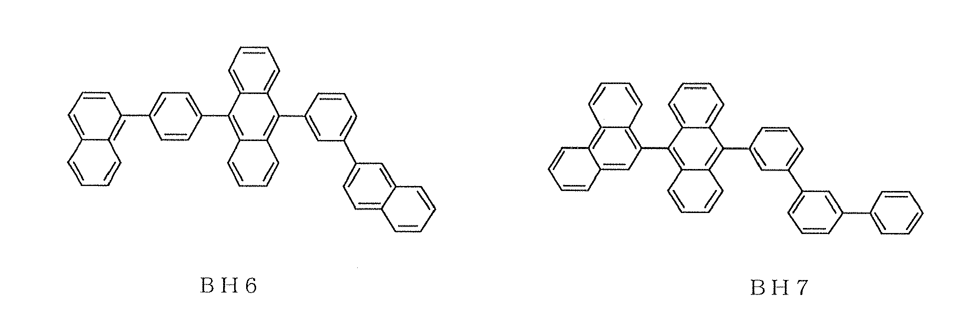

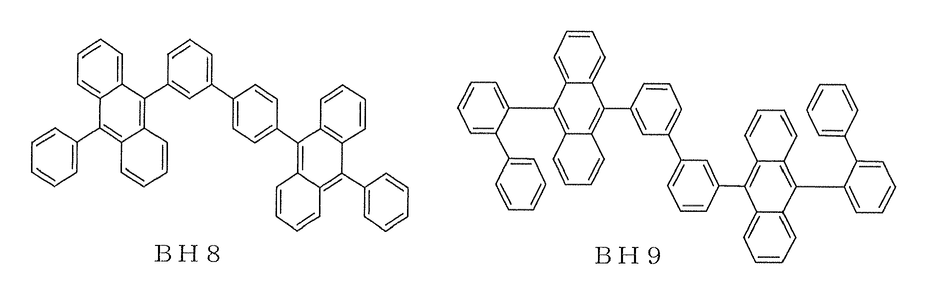

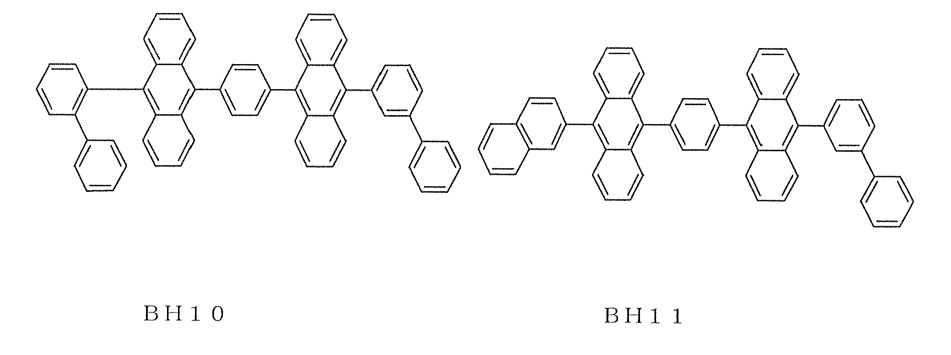

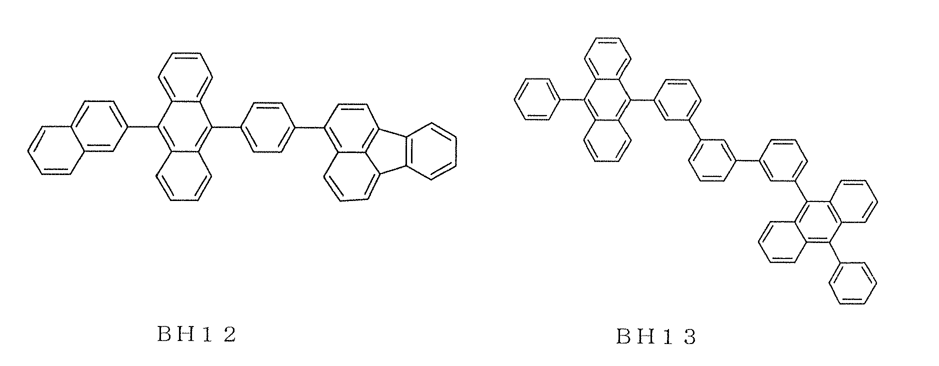

Hereinafter, the asymmetric pyrene-based compound to be used in the present invention will be described.
The asymmetric pyrene-based compound is preferably a compound represented by the following general formula (V).

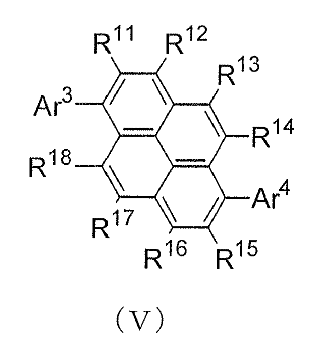

In the general formula (V), Ar³ and Ar⁴ each independently represent a substituted or unsubstituted aryl group having 6 to 50 nuclear carbon atoms, provided that Ar³ and Ar⁹ do not have the same structure; and
R¹¹ to R¹⁸ each independently represent a hydrogen atom, a substituted or unsubstituted aryl group having 6 to 50 nuclear carbon atoms, a substituted or unsubstituted aromatic heterocyclic group having 5 to 50 nuclear atoms, a substituted or unsubstituted alkyl group having 1 to 50 carbon atoms, a substituted or unsubstituted alkoxy group having 1 to 50 carbon atoms, a substituted or unsubstituted aralkyl group having 6 to 50 carbon atoms, a substituted or unsubstituted aryloxy group having 5 to 50 nuclear atoms, a substituted or unsubstituted arylthio group having 5 to 50 nuclear atoms, a substituted or unsubstituted alkoxycarbonyl group having 1 to 50 carbon atoms, a carboxyl group, a halogen atom, a cyano group, a nitro group, or a hydroxyl group.
Examples of the aryl group represented by each of Ar³ to Ar⁴ in the general formula (V) include the same groups as those of Ar¹ and Ar² in the general formula (I).
Examples of each of the aryl group, the aromatic heterocyclic group, the alkyl group, the alkoxy group, the aralkyl group, the aryloxy group, the arylthio group, and the alkoxycarbonyl group each represented by each of R¹¹ to R¹⁸ in the general formula (V) include the same groups as those of R¹ to R⁸ in the general formula (I).

In addition, the asymmetric pyrene-based compound to be used for the white color organic EL device of the present invention is preferably a compound represented by any one of the following general formulae (VI) to (IX).

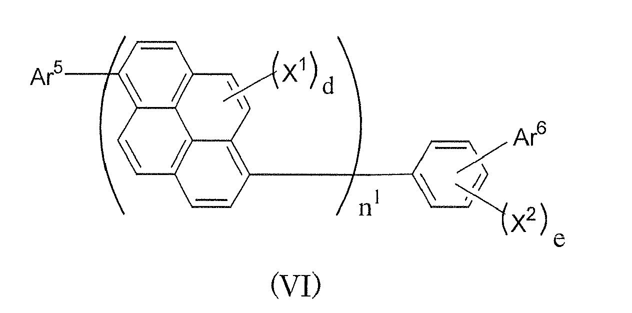

In the general formula (VI), Ar⁵ represents a substituted or unsubstituted fused aromatic ring residue having 10 to 50 nuclear carbon atoms;
Ar⁶ represents a substituted or unsubstituted aryl group having 6 to 50 nuclear carbon atoms, and the number of Ar⁶s may be two or more;
X¹ and X² each independently represent a substituted or unsubstituted aryl group having 6 to 50 nuclear carbon atoms, a substituted or unsubstituted aromatic heterocyclic group having 5 to 50 nuclear atoms, a substituted or unsubstituted alkyl group having 1 to 50 carbon atoms, a substituted or unsubstituted alkoxy group having 1 to 50 carbon atoms, a substituted or unsubstituted aralkyl group having 6 to 50 carbon atoms, a substituted or unsubstituted aryloxy group having 5 to 50 nuclear atoms, a substituted or unsubstituted arylthio group having 5 to 50 nuclear atoms, a substituted or unsubstituted alkoxycarbonyl group having 1 to 50 carbon atoms, a carboxyl group, a halogen atom, a cyano group, a nitro group, or a hydroxyl group; and
**d** represents an integer of 0 to 8, **e** represents an integer of 0 to 4, and n¹ represents an integer of 1 to 3.
Examples of the fused aromatic ring residue represented by Ar⁵ in the general formula (VI) include the same groups as those of Ar in the general formula (II).
Examples of the aryl group represented by Ar⁶ in the general formula (VI) include the same groups as those described above.
Examples of each of the aryl group, the aromatic heterocyclic group, the alkyl group, the alkoxy group, the aralkyl group, the aryloxy group, the arylthio group, and the alkoxycarbonyl group each represented by each of X¹ and X² in the general formula (VI) include the same groups as those described above.

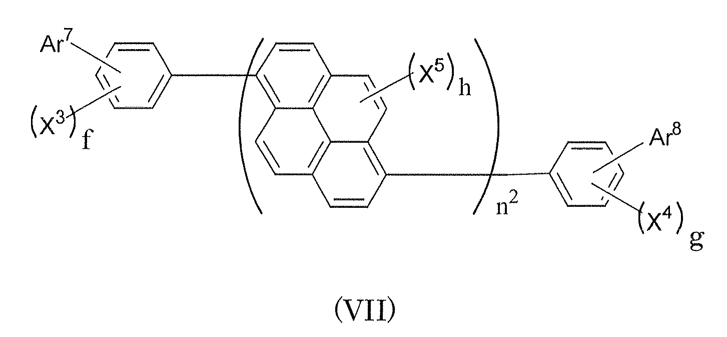

In the general formula (VII), Ar⁷ and Ar⁸ each independently represent a substituted or unsubstituted aryl group having 6 to 50 nuclear carbon atoms, and each of the number of Ar⁷s and the number of Ar⁸s may be two or more;
X³, X⁴, and X⁵ each independently represent a substituted or unsubstituted aryl group having 6 to 50 nuclear carbon atoms, a substituted or unsubstituted aromatic heterocyclic group having 5 to 50 nuclear atoms, a substituted or unsubstituted alkyl group having 1 to 50 carbon atoms, a substituted or unsubstituted alkoxy group having 1 to 50 carbon atoms, a substituted or unsubstituted aralkyl group having 6 to 50 carbon atoms, a substituted or unsubstituted aryloxy group having 5 to 50 nuclear atoms, a substituted or unsubstituted arylthio group having 5 to 50 nuclear atoms, a substituted or unsubstituted alkoxycarbonyl group having 1 to 50 carbon atoms, a carboxyl group, a halogen atom, a cyano group, a nitro group, or a hydroxyl group; and
**f** and **g** each represent an integer of 0 to 4, **h** represents an integer of 0 to 8, and n² represents an integer of 1 to 3, provided that no symmetrical group binds to each of 1-position and 6-position of central pyrene.
Examples of the aryl group represented by each of Ar⁷ and Ar⁸ in the general formula (VII) include the same groups as those described above.
Examples of each of the aryl group, the aromatic heterocyclic group, the alkyl group, the alkoxy group, the aralkyl group, the aryloxy group, the arylthio group, and the alkoxycarbonyl group each represented by each of X³, X⁴, and X⁵ in the general formula (VII) include the same groups as those described above.

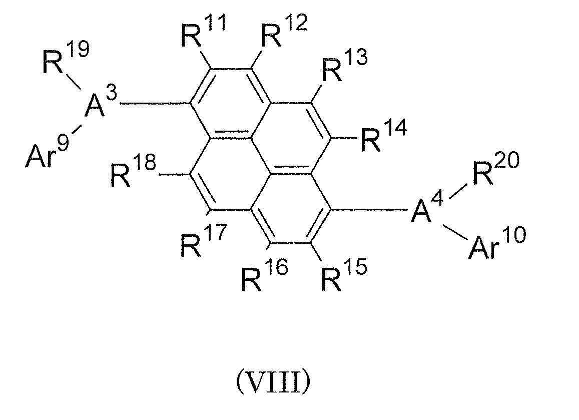

In the general formula (VIII), A³ and A⁴ each independently represent a substituted or unsubstituted fused aromatic ring residue having 10 to 20 nuclear carbon atoms;
Ar⁹ and Ar¹⁰ each independently represent a hydrogen atom, or a substituted or unsubstituted aryl group having 6 to 50 nuclear carbon atoms, and each of the number of Ar⁹s and the number of Ar¹⁰s may be two or more; and
R¹¹ to R²⁰ each independently represent a hydrogen atom, a substituted or unsubstituted aryl group having 6 to 50 nuclear carbon atoms, a substituted or unsubstituted aromatic heterocyclic group having 5 to 50 nuclear atoms, a substituted or unsubstituted alkyl group having 1 to 50 carbon atoms, a substituted or unsubstituted alkoxy group having 1 to 50 carbon atoms, a substituted or unsubstituted aralkyl group having 6 to 50 carbon atoms, a substituted or unsubstituted aryloxy group having 5 to 50 nuclear atoms, a substituted or unsubstituted arylthio group having 5 to 50 nuclear atoms, a substituted or unsubstituted alkoxycarbonyl group having 1 to 50 carbon atoms, a carboxyl group, a halogen atom, a cyano group, a nitro group, or a hydroxyl group, and each of the number of R¹⁹s and the number of R²⁰s may be two or more, provided that no symmetrical group binds to each of 1-position and 6-position of central pyrene.
Examples of the fused aromatic ring residue represented by each of A³ and A⁴ in the general formula (VIII) include those each having a matching valence out of the examples of the fused aromatic ring residue represented by Ar in the general formula (II).
Examples of the aryl group represented by each of Ar⁹ and Ar¹⁰ in the general formula (VIII) include the same groups as those described above.
Examples of each of the aryl group, the aromatic heterocyclic group, the alkyl group, the alkoxy group, the aralkyl group, the aryloxy group, the arylthio group, and the alkoxycarbonyl group each represented by each of R¹¹ to R²⁰ in the general formula (VIII) include the same groups as those described above.

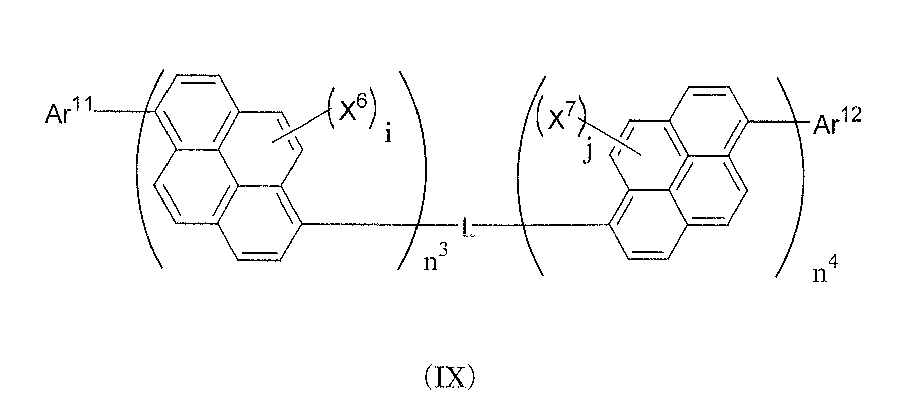

In the general formula (IX), Ar¹¹ and Ar¹² each independently represent a substituted or unsubstituted aryl group having 6 to 50 nuclear carbon atoms;
X⁶ and X⁷ each independently represent a substituted or unsubstituted aryl group having 6 to 50 nuclear carbon atoms, a substituted or unsubstituted aromatic heterocyclic group having 5 to 50 nuclear atoms, a substituted or unsubstituted alkyl group having 1 to 50 carbon atoms, a substituted or unsubstituted alkoxy group having 1 to 50 carbon atoms, a substituted or unsubstituted aralkyl group having 6 to 50 carbon atoms, a substituted or unsubstituted aryloxy group having 5 to 50 nuclear atoms, a substituted or unsubstituted arylthio group having 5 to 50 nuclear atoms, a substituted or unsubstituted alkoxycarbonyl group having 1 to 50 carbon atoms, a carboxyl group, a halogen atom, a cyano group, a nitro group, or a hydroxyl group;
L represents a substituted or unsubstituted arylene group having 6 to 50 nuclear carbon atoms, or a substituted or unsubstituted divalent aromatic heterocyclic group having 3 to 50 nuclear atoms; and
**i** and **j** each represent an integer of 0 to 8, and n³ and n⁴ each represent an integer of 1 to 3.
Examples of the aryl group represented by each of Ar¹¹ and Ar¹² in the general formula (IX) include the same groups as those described above.
Examples of each of the aryl group, the aromatic heterocyclic group, the alkyl group, the alkoxy group, the aralkyl group, the aryloxy group, the arylthio group, and the alkoxycarbonyl group each represented by each of X⁶ and X⁷ in the general formula (IX) include the same groups as those described above.
Examples of the arylene group and the divalent aromatic heterocyclic group represented by L in the general formula (IX) include those obtained by making the examples of the aryl group and the aromatic heterocyclic group represented by Ar¹ and Ar² in the general formula (I) divalent.

Specific examples of the asymmetric pyrene-based compound represented by any one of the general formulae (VI) to (IX) are shown below. However, the compound is not limited to these exemplified compounds.

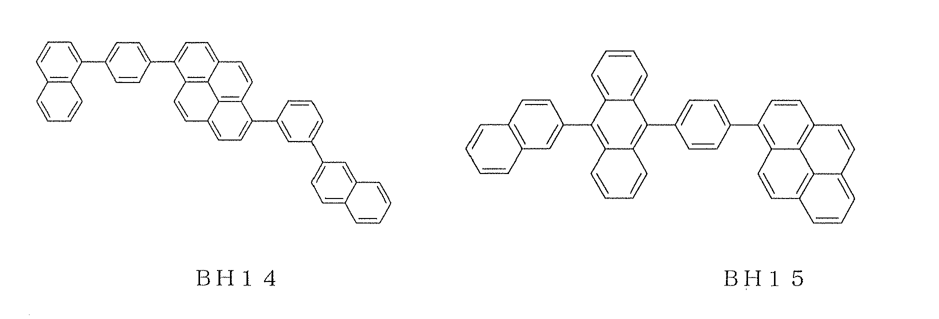

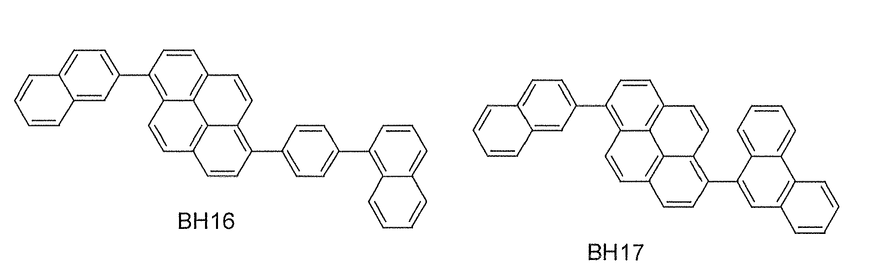

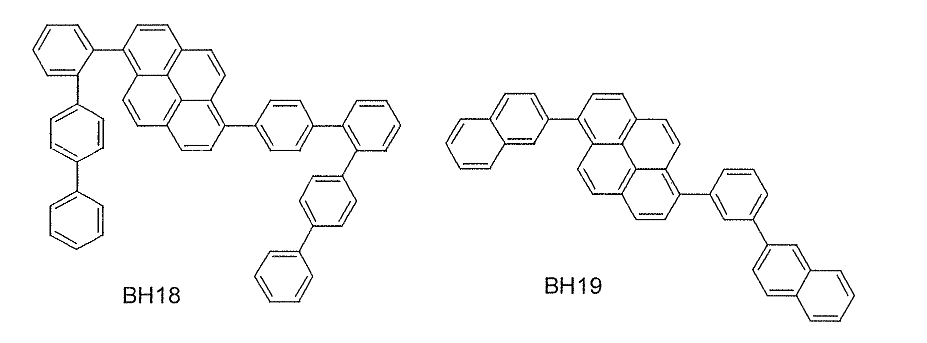

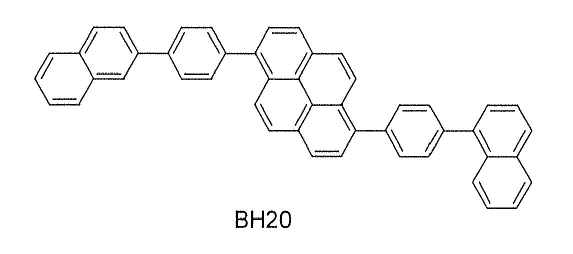

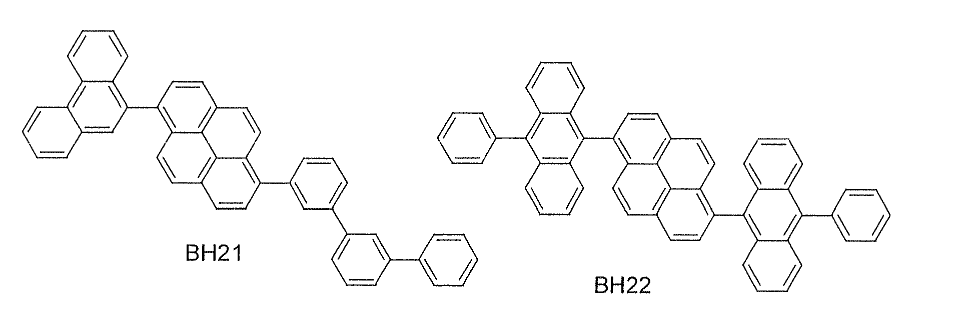

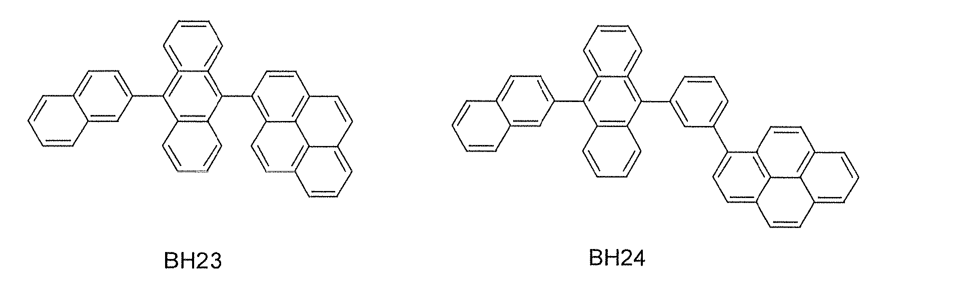

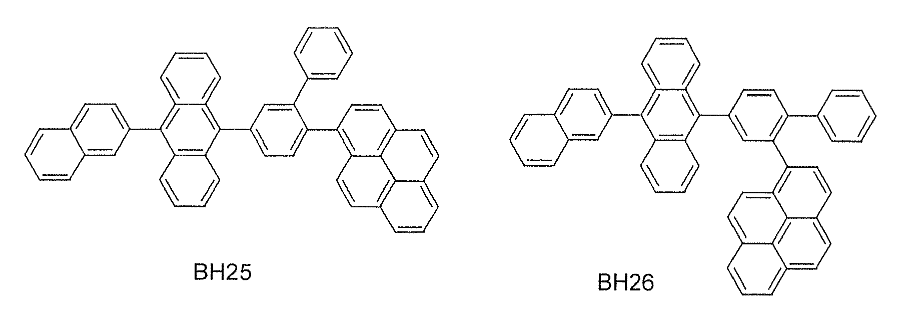

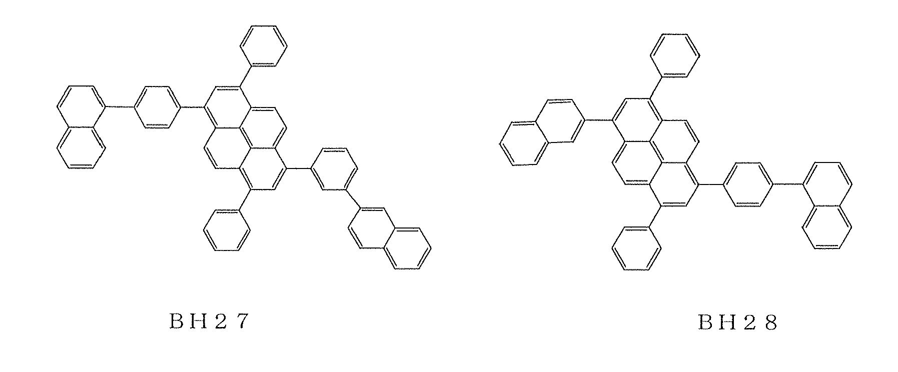

The bluish color dopant to be used for the white color organic EL device of the present invention is not particularly limited, but is preferably at least one compound selected from styrylamine, an amine-substituted styryl compound, a compound containing an amine-substituted fused aromatic ring, and a compound containing a fused aromatic ring.
Examples of styrylamine and the amine-substituted styryl compound include compounds represented by the following general formulae [i] and [ii]. Examples of the fused aromatic ring-containing compound include compounds each represented by the following general formula [iii].

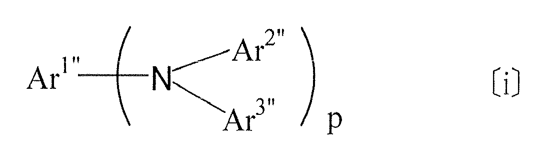

In the formula, Ar¹", Ar²", and Ar³" each independently represent a substituted or unsubstituted aromatic group having 6 to 40 carbon atoms, at least one of them includes a styryl group, and **p** represents an integer of 1 to 3.
Specific examples of the aromatic group include the same groups as those described above.

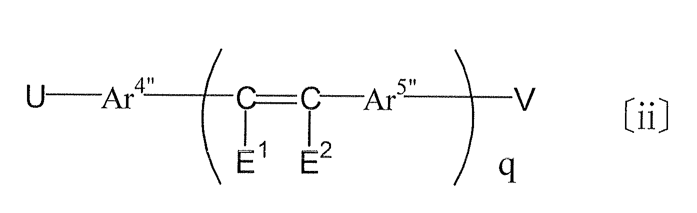

In the formula, Ar⁴" and Ar⁵" each independently represent a substituted or unsubstituted arylene group having 6 to 30 carbon atoms, E¹ and E² each independently represent a substituted or unsubstituted aryl or alkyl group having 6 to 30 carbon atoms, a hydrogen atom, or a cyano group, and **q** represents an integer of 1 to 3. At least one of **U** and **V** is a substituent including an amino group, and the amino group is preferably an arylamino group.
Specific examples of the aryl group and the alkyl group include the same groups as those described above. Specific examples of the arylene group include those obtained by removing one hydrogen atom from each of the examples of the aryl group.

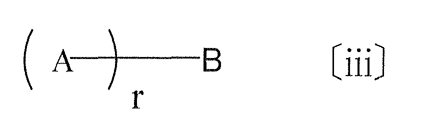

In the formula, **A** represents a substituted or unsubstituted alkyl or alkoxy group having 1 to 16 carbon atoms, a substituted or unsubstituted aryl group having 6 to 30 carbon atoms, a substituted or unsubstituted alkylamino group having 6 to 30 carbon atoms, or a substituted or unsubstituted arylamino group having 6 to 30 carbon atoms, **B** represents a fused aromatic ring residue having 10 to 40 carbon atoms, and **r** represents an integer of 1 to 4.
Specific examples of the respective groups such as the alkyl group include the same groups as those described above.

In the white color organic EL device of the present invention including the anode, the bluish color light emitting layer, the yellow-to-reddish color light emitting layer, and the cathode in this order, the yellow-to-reddish color light emitting layer preferably contains the same host material as that of the bluish color light emitting layer and a yellow-to-reddish color dopant.
In addition, the yellow-to-reddish color dopant is preferably a compound having a fluoranthene skeleton or a perylene skeleton, or more preferably a compound having multiple fluoranthene skeletons Furthermore, the yellow-to-reddish color dopant is preferably a compound having a fluorescence peak wavelength of 540 nm to 700 nm.
Examples of the compound having a fluoranthene skeleton or a perylene skeleton include compounds represented by the following general formulae [1] to [17].

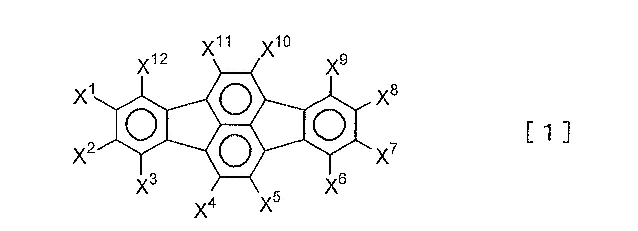

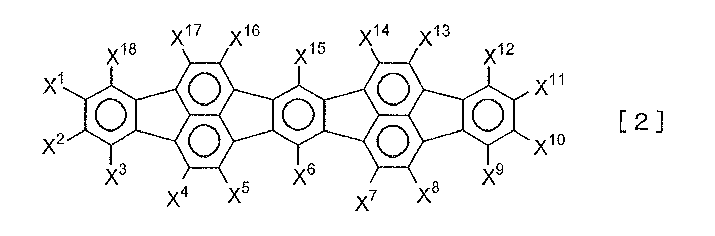

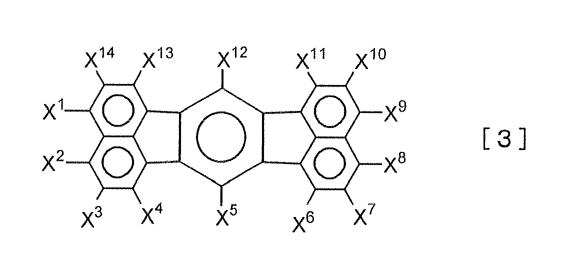

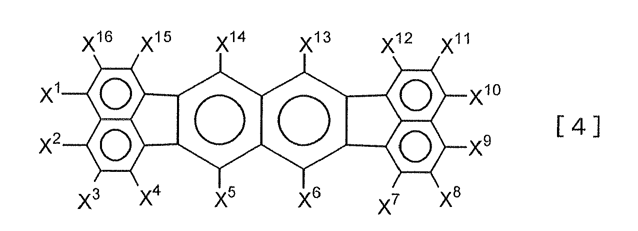

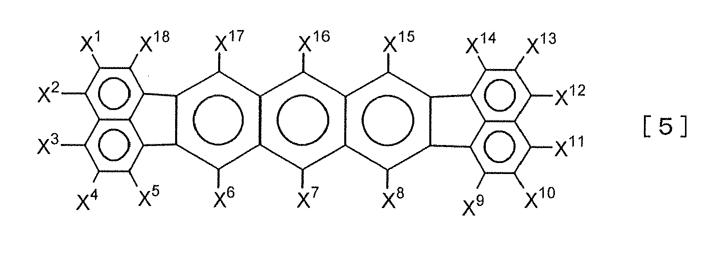

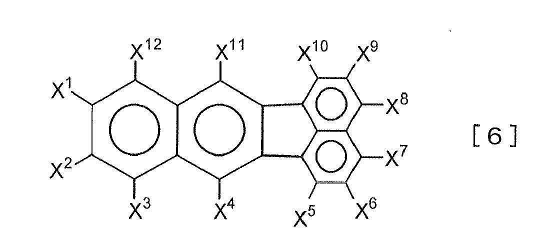

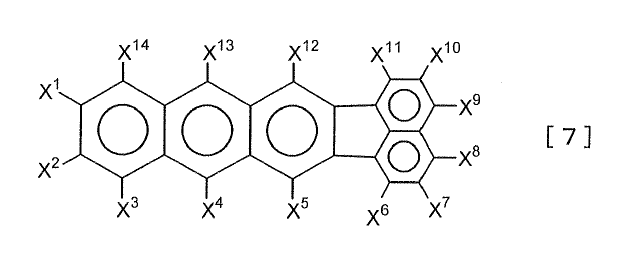

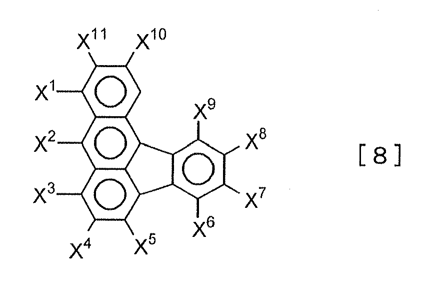

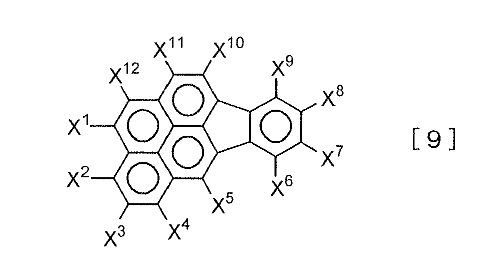

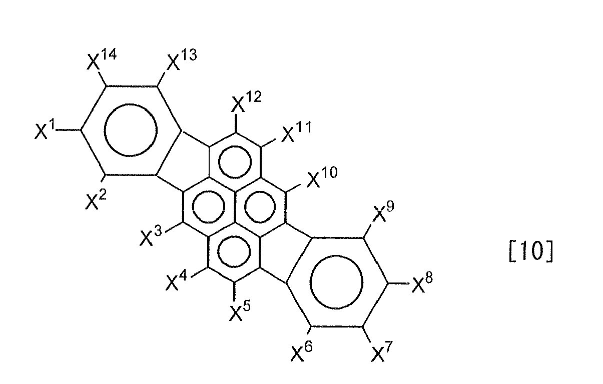

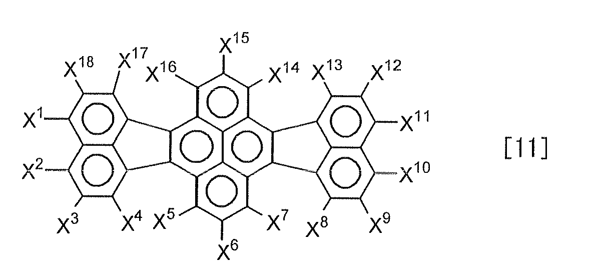

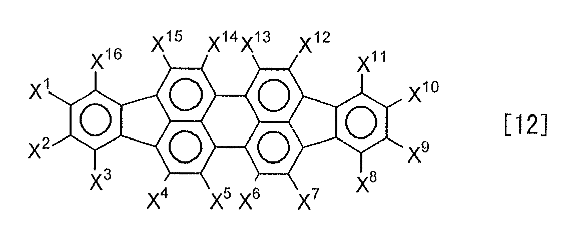

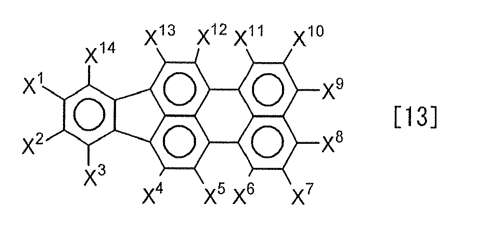

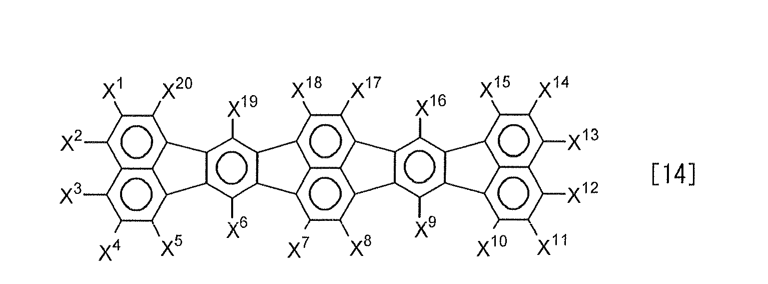

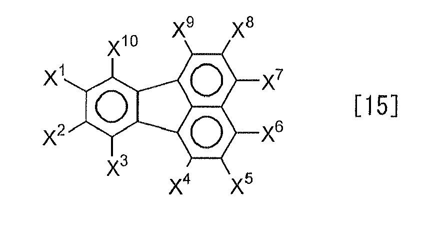

In each of the general formulae [1] to [15], X¹ to x²⁰ each independently represent a hydrogen atom, a linear, branched, or cyclic alkyl group having 1 to 20 carbon atoms, a linear, branched, or cyclic alkoxy group having 1 to 20 carbon atoms, a substituted or unsubstituted aryl group having 6 to 30 carbon atoms, a substituted or unsubstituted aryloxy group having 6 to 30 carbon atoms, a substituted or unsubstituted arylamino group having 6 to 30 carbon atoms, a substituted or unsubstituted alkylamino group having 1 to 30 carbon atoms, a substituted or unsubstituted arylalkylamino group having 7 to 30 carbon atoms, or a substituted or unsubstituted alkenyl group having 8 to 30 carbon atoms, and adjacent substituents and X¹ to X²⁰ may bond each other to form cyclic structures. When the adjacent substituents are aryl groups, the substituents may be identical to each other.
Specific examples of the respective groups such as the alkyl group include the same groups as those described above. Examples of the alkenyl group include those obtained by providing the specific examples of the alkyl group with double bonds.
In addition, a compound represented by any one of the general formulae [1] to [15] preferably contains an amino group or an alkenyl group.

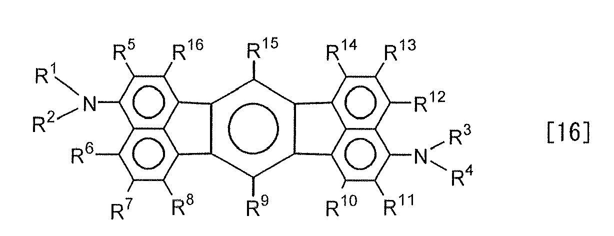

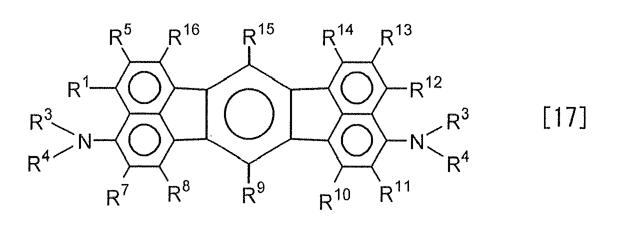

In each of the general formulae [16] and [17], R¹ to R⁴ each independently represent an alkyl group having 1 to 20 carbon atoms, or a substituted or unsubstituted aryl group having 6 to 30 carbon atoms, and R¹ and R² and/or R³ and R⁴ may bond each other via a carbon-carbon bond, -O-, or -S-. R⁵ to R¹⁶ each represent a hydrogen atom, a linear, branched, or cyclic alkyl group having 1 to 20 carbon atoms, a linear, branched, or cyclic alkoxy group having 1 to 20 carbon atoms, a substituted or unsubstituted aryl group having 6 to 30 carbon atoms, a substituted or unsubstituted aryloxy group having 6 to 30 carbon atoms, a substituted or unsubstituted arylamino group having 6 to 30 carbon atoms, a substituted or unsubstituted alkylamino group having 1 to 30 carbon atoms, a substituted or unsubstituted arylalkylamino group having 7 to 30 carbon atoms, or a substituted or unsubstituted alkenyl group having 8 to 30 carbon atoms, and adjacent substituents and R⁵ to R¹⁶ may bond each other to form cyclic structures. At least one of R⁵ to R¹⁶ in each formula preferably contains amine or an alkenyl group.
Specific examples of the respective groups such as the alkyl group include the same groups as those described above. Examples of the alkenyl group include those obtained by providing the specific examples of the alkyl group with double bonds.

In addition, such fluorescent compound having a fluoranthene skeleton as described above preferably contains an electron-donating group for providing high efficiency and a long lifetime. A substituted or unsubstituted arylamino group is a preferable electron-donating group. Furthermore, the fluorescent compound having a fluoranthene skeleton preferably has five or more condensed rings, or particularly preferably has six or more condensed rings. This is because the fluorescent compound has a fluorescence peak wavelength of 540 to 700 nm, and light emission from a bluish color light emitting material and light emission from the fluorescent compound overlap each other to provide a white color. The fluorescent compound preferably has multiple fluoranthene skeletons. A particularly preferable fluorescent compound has an electron-donating group and a fluoranthene skeleton or a perylene skeleton, and shows a fluorescence peak wavelength of 540 to 700 nm.

Hereinafter, a layer except the light emitting layer constituting the white color organic EL device of the present invention will be described.
The white color organic EL device of the present invention is produced on a translucent substrate. The term "translucent substrate" as used herein refers to a substrate for supporting an organic EL device, and a smooth substrate having a transmittance for light in a visible region ranging from 400 to 700 nm of 50% or more is preferable. Specific examples thereof include a glass sheet and a polymer sheet. In particular, examples of the glass sheet include a soda lime glass, a barium/strontium-containing glass, a lead glass, an aluminosilicate glass, a borosilicate glass, a bariumborosilicate glass, and quartz. Examples of the polymer sheet include polycarbonate, acryl, polyethylene terephthalate, polyether sulfide, and polysulfone.

The white color organic EL device of the present invention may have a hole injecting layer, a hole transporting layer, an organic semiconductor layer, or the like sandwiched between the anode and the light emitting layer. The hole injecting layer and the hole transporting layer are layers for aiding the injection of a hole into the light emitting layer and for transporting the hole to a light emitting region. Each of them has a large hole mobility, and generally has a small ionization energy of 5.5 eV or less. The hole injecting layer is arranged for the adjustment of an energy level such as the alleviation of an abrupt change in energy level. A material for transporting a hole to the light emitting layer at a reduced electric field intensity is preferable for such hole injecting layer and hole transporting layer. A material having a hole mobility of at least 10⁻⁶ cm²/V · s upon application of, for example, an electric field of 10⁴ to 10⁶ V/cm is more preferable therefor. A material of which each of the hole injecting layer and the hole transporting layer is formed is not particularly limited as long as the material has the above-described preferable properties. A material to be used can be selected from those conventionally used as hole charge transport materials in photoconductive materials and conventionally known materials used for hole injecting layers of organic EL devices.

Specific examples of the materials for forming each of such hole injecting layer and hole transporting layer include: a triazole derivative (see, for example USP 3,112,197); an oxadiazole derivative (see, for example USP 3, 189, 447); an imidazole derivative (see, for example JP-B-37-16096) ; a polyarylalkane derivative (see, for example USP 3, 615, 402, USP 3,820,989 and USP 3,542,544, JP-B-45-555, JP-B-51-10983, JP-A-51-93224, JP-A-55-17105, JP-A-56-4148, JP-A-55-108667, JP-A-55-156953, andJP-A-56-36656); a pyrazoline derivative and a pyrazolone derivative (see, for example USP 3,180,729, USP 4,278,746, JP-A-55-88064, JP-A-55-88065, JP-A-49-105537, JP-A-55-51086, JP-A-56-80051, JP-A-56-88141, JP-A-57-45545, JP-A-54-112637, and JP-A-55-74546); a phenylenediamine derivative (see, for example USP 3,615,404, JP-B-51-10105, JP-B-46-3712, JP-B-47-25336, JP-A-54-53435, JP-A-54-110536, and JP-A-54-119925); an arylamine derivative (see, for example USP 3,567,450, USP 3,180,703, USP 3,240,597, USP 3,658,520, USP 4, 232, 103, USP 4,175,961, USP 4,012,376, JP-B-49-35702, JP-B-39-27577, JP-A-55-144250, JP-A-56-119132, JP-A-56-22437, and DE 1,110,518); an amino-substituted chalcone derivative (see, for example USP 3,526,501); an oxazole derivative (those disclosed in USP 3,257,203); a styrylanthracene derivative (see, for example JP-A-56-46234); a fluorenone derivative (see, for example JP-A-54-110837); a hydrazone derivative (see, for example USP 3, 717, 462, JP-A-54-59143, JP-A-55-52063, JP-A-55-52064, JP-A-55-46760, JP-A-55-85495, JP-A-57-11350, JP-A-57-148749, and JP-A-2-311591); a stilbene derivative (see, for example JP-A-61-210363, JP-A-61-228451, JP-A-61-14642, JP-A-61-72255, JP-A-62-47646, JP-A-62-36674, JP-A-62-10652, JP-A-62-30255, JP-A-60-93445, JP-A-60-94462, JP-A-60-174749, and JP-A-60-175052); a silazane derivative (USP 4,950,950); a polysilane-based (JP-A-2-204996); an aniline-based copolymer (JP-A-2-282263); an electroconductive high molecular weight oligomer (particularly a thiophene oligomer) disclosed in JP-A-1-211399; a porphyrin compound (those disclosed in, for example, JP-A-63-295695); an aromatic tertiary amine compound and a styrylamine compound (see, for example USP 4,127,412, JP-A-53-27033, JP-A-54-58445, JP-A-54-149634, JP-A-54-64299, JP-A-55-79450, JP-A-55-144250, JP-A-56-119132, JP-A-61-295558, JP-A-61-98353, and JP-A-63-295695); and an aromatic tertiary amine compound having two fused aromatic rings in the molecule disclosed in USP 5, 061, 569, such as 4,4'-bis(N-(1-naphthyl)-N-phenylamino)biphenyl, and 4,4',4"-tris(N-(3-methylphneyl)-N-phenylamino)triphenylamine disclosed in JP-A-4-308688, in which three triphenylamine units are bonded in a star-burst type can be exemplified. Further, inorganic compounds such as p-type Si and p-type SiC may also be used.

Each of the hole injecting layer and the hole transporting layer in the present invention may be constituted of a single layer composed of one or more kinds of the above-described materials, or a hole injecting layer or a hole transporting layer composed of another compound may be laminated. The thickness of each of the hole injecting layer and the hole transporting layer is not particularly limited, but is preferably 20 to 200 nm.
In addition, the organic semiconductor layer is a layer for aiding the injection of a hole or an electron into the light emitting layer, and a layer having a conductivity of 10⁻¹⁰ S/cm or more is suitable. Examples of a material for such organic semiconductor layer include: a thiophene-containing oligomer; a conductive oligomer such as an arylamine-containing oligomer described in JP-A-08-193191; and a conductive dendrimer such as an arylamine-containing dendrimer. The thickness of the organic semiconductor layer is not particularly limited, but is preferably 10 to 1,000 nm.

The white color organic EL device of the present invention may have an electron injecting layer, an electron transporting layer, an adhesion improving layer, or the like sandwiched between the cathode and the light emitting layer. The electron injecting layer and the electron transporting layer are layers for aiding the injection of an electron into the light emitting layer, and each of them has a large electron mobility. The electron injecting layer is arranged for the adjustment of an energy level such as the alleviation of an abrupt change in energy level. The adhesion improving layer is a layer composed of a material having particularly good adhesiveness with the cathode out of the electron injecting layers. A metal complex of 8-hydroxyquinoline or a derivative thereof is a suitable material for each of the electron injecting layer and the electron transporting layer. Specific examples of the metal complex of 8-hydroxyquinoline or a derivative thereof to be used include metal chelate oxynoid compounds each containing a chelate of an oxine (generally 8-quinolinol or 8-hydroxyquinoline) such as tris(8-quinolinol)aluminum. In addition, examples of an oxadiazole derivative include electron transmission compounds represented by the following general formulae (1) to (3).

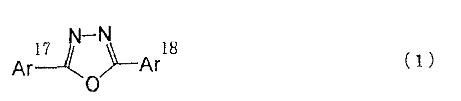

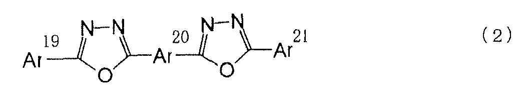

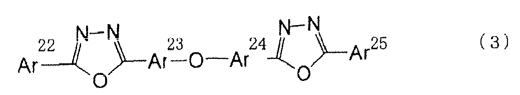

In the formulae, Ar¹⁷, Ar¹⁸, Ar¹⁹, Ar²¹, Ar²², and Ar²⁵ each represent a substituted or unsubstituted aryl group, and Ar¹⁷ and Ar¹⁸, Ar¹⁹ and Ar²¹, or Ar²² and Ar²⁵ may be identical to or different from each other. Ar²⁰, Ar²³, and Ar²⁴ each represent a substituted or unsubstituted arylene group, and Ar²³ and Ar²⁹ may be identical to or different from each other.)
Examples of the aryl groups in the general formulae (1) to (3) include a phenyl group, a biphenyl group, an anthranyl group, a perylenyl group, and a pyrenyl group. Examples of the arylene groups include a phenylene group, a naphthylene group, a biphenylene group, an anthranylene group, a perylenylene group, and a pyrenylene group. In addition, examples of substituents for them include an alkyl group having 1 to 10 carbon atoms, an alkoxy group having 1 to 10 carbon atoms, and a cyano group. An electron transmission compound having good thin film formability is preferably used.
Specific examples of the electron transmission compounds include the following.

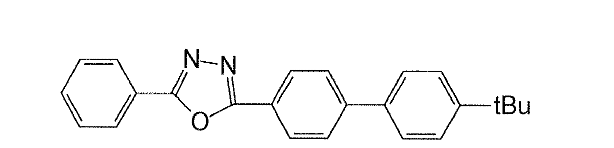

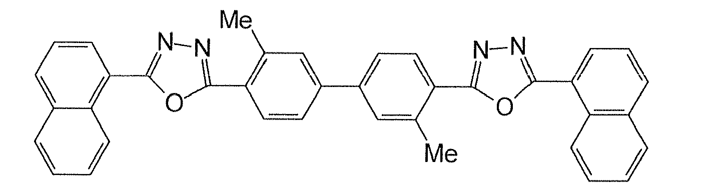

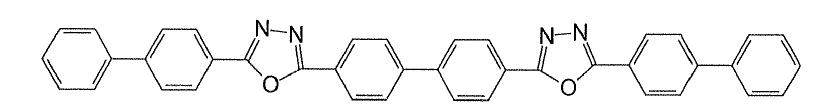

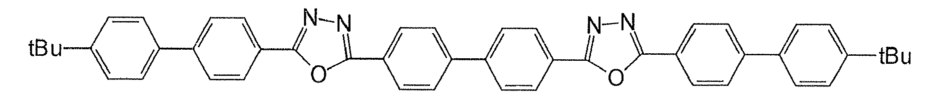

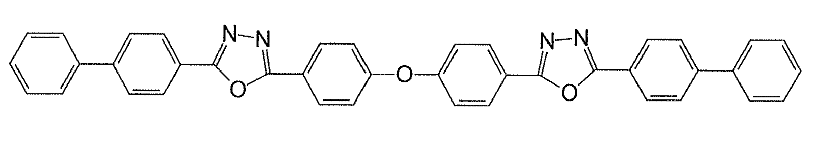

Furthermore, those represented by the following general formulae (4) to (8) can be also used as materials to be used for the electron injecting layer and the electron transporting layer.

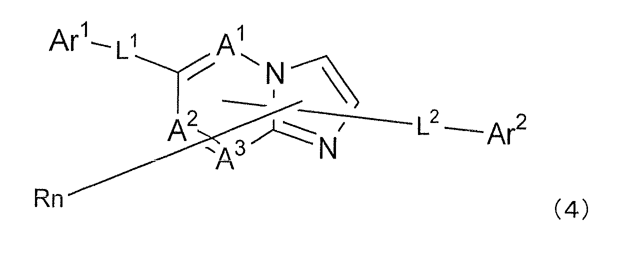

In the formula, A¹ to A³ each independently represent a nitrogen atom or a carbon atom;
Ar¹ represents a substituted or unsubstituted aryl group having 6 to 60 nuclear carbon atoms, or a substituted or unsubstituted heteroaryl group having 3 to 60 nuclear carbon atoms, and Ar² represents a hydrogen atom, a substituted or unsubstituted aryl group having 6 to 60 nuclear carbon atoms, a substituted or unsubstituted heteroaryl group having 3 to 60 nuclear carbon atoms, a substituted or unsubstituted alkyl group having 1 to 20 carbon atoms, or a substituted or unsubstituted alkoxy group having 1 to 20 carbon atoms, provided that one of Ar¹ and Ar² represents a substituted or unsubstituted condensed ring group having 10 to 60 nuclear carbon atoms, or a substituted or unsubstituted monohetero condensed ring group having 3 to 60 nuclear carbon atoms;
L¹ and L²each independently represent a single bond, a substituted or unsubstituted arylene group having 6 to 60 nuclear carbon atoms, a substituted or unsubstituted heteroarylene group having 3 to 60 nuclear carbon atoms, or a substituted or unsubstituted fluorenylene group;
**R** represents a hydrogen atom, a substituted or unsubstituted aryl group having 6 to 60 nuclear carbon atoms, a substituted or unsubstituted heteroaryl group having 3 to 60 nuclear carbon atoms, a substituted or unsubstituted alkyl group having 1 to 20 carbon atoms, or a substituted or unsubstituted alkoxy group having 1 to 20 carbon atoms, n represents an integer of 0 to 5, and when n is 2 or more, multiple Rs may be identical to or different from each other, or multiple adjacent **R** groups may bond each other to form a carbocyclic aliphatic ring or a carbocyclic aromatic ring.
Specific examples of the respective groups such as the alkyl group include the same groups as those described above.

A heterocyclic derivative containing nitrogen atom expressed by a following formula (5):

HAr-L-Ar¹-Ar² (5)

wherein HAr represents a heterocyclic ring containing nitrogen atom and having 3 to 40 carbon atoms which may have a substituent, **L** represents a single bond, an arylene group having 6 to 60 carbon atoms which may have a substituent, a heteroarylene group having 3 to 60 carbon atoms which may have a substituent, or a fluorenylene group which may have a substituent, Ar¹ represents a divalent aromatic hydrocarbon group having 6 to 60 carbon atoms which may have a substituent, and Ar² represents an aryl group having 6 to 60 carbon atoms which may have a substituent, or a heteroaryl group having 3 to 60 carbon atoms which may have a substituent. Specific examples of the respective groups such as the aryl group include the same groups as those described above.

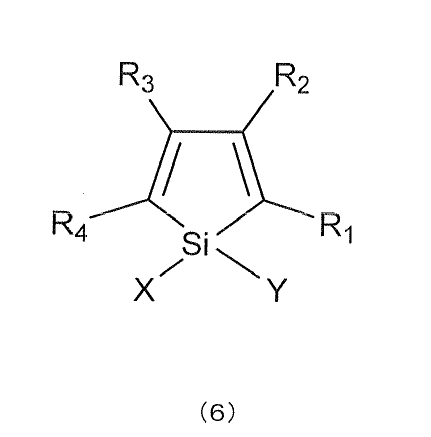

In the formula, **X** and **Y** each independently represent a saturated or unsaturated hydrocarbon group having 1 to 6 carbon atoms, an alkoxy group, an alkenyloxy group, an alkynyloxy group, a hydroxy group, a substituted or unsubstituted aryl group, or a substituted or unsubstituted hetero ring, or a saturated or unsaturated ring structure formed by bonding **X** and **Y** each other, and R¹ to R⁴ each independently represent hydrogen, a halogen atom, a substituted or unsubstituted alkyl group having 1 to 6 carbon atoms, an alkoxy group, an aryloxy group, a perfluoroalkyl group, a perfluoroalkoxy group, an amino group, an alkylcarbonyl group, an arylcarbonyl group, an alkoxycarbonyl group, an aryloxycarbonyl group, an azo group, an alkylcarbonyloxy group, an arylcarbonyloxy group, an alkoxycarbonyloxy group, an aryloxycarbonyloxy group, a sulfinyl group, a sulfonyl group, a sulfanyl group, a silyl group, a carbamoyl group, an aryl group, a hetero ring group, an alkenyl group, an alkynyl group, a nitro group, a formyl group, a nitroso group, a formyloxy group, an isocyano group, a cyanate group, an isocyanate group, a thiocyanate group, an isothiocyanate group, or a cyano group, or, when they are adjacent to each other, structures in which substituted or unsubstituted rings are condensed includes.) Specific examples of the respective groups such as the alkyl group include the same groups as those described above.

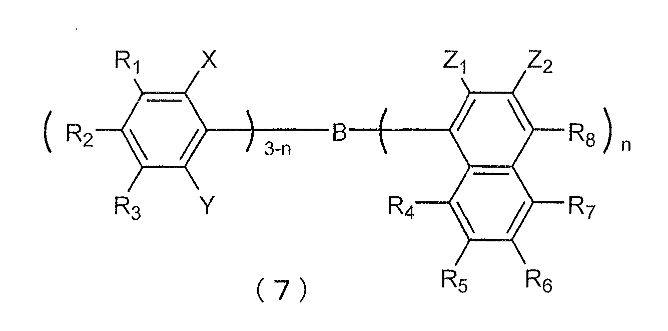

In the formula, R₁ to R₈ and Z₂ each independently represent a hydrogen atom, a saturated or unsaturated hydrocarbon group, an aromatic group, a hetero ring group, a substituted amino group, a substituted boryl group, an alkoxy group, or an aryloxy group, **X**, **Y,** and Z₁ each independently represent a saturated or unsaturated hydrocarbon group, an aromatic group, a hetero ring group, a substituted amino group, an alkoxy group, or an aryloxy group, substituents of Z₁ and Z₂ may bond each other to form a condensed ring, **n** represents an integer of 1 to 3, and, when **n** is 2 or more, Z₁s may be different from each other, provided that the case where **n** is 1, **X, Y,** and R₂ represent methyl groups, and R₈ represents a hydrogen atom or a substituted boryl group and the case where **n** is 3 and Z₁ represents a methyl group are excluded.

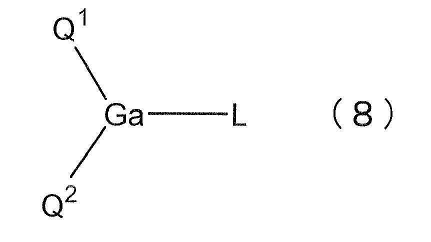

In the formula, Q¹ and Q² each independently represent a ligand represented by the following general formula (9), and **L** represents a halogen atom, a substituted or unsubstituted alkyl group; a substituted or unsubstituted cycloalkyl group; a substituted or unsubstituted aryl group; a substituted or unsubstituted heterocyclic group; -OR¹ wherein R¹ represents a hydrogen atom, a substituted or unsubstituted alkyl group, a substituted or unsubstituted cycloalkyl group; a substituted or unsubstituted aryl group, or a substituted or unsubstituted heterocyclic group; or a ligand represented by -O-Ga-Q³ (Q⁴) wherein Q³ and Q⁴ are identical to Q¹ and Q².

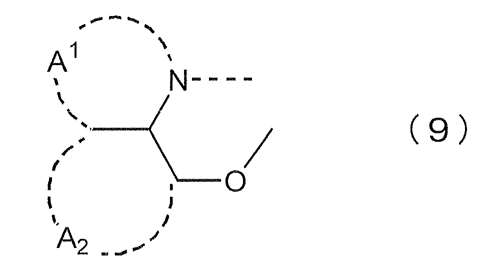

wherein rings A¹ and A² are six-membered aryl ring structures which may have substituents and are mutually condensed.

The metal complex has strong property as an n-type semiconductor, and has a large electron injection ability. Furthermore, production energy upon formation of the complex is low, so connectivity between the metal of the formed metal complex and a ligand is strong and the fluorescence quantum efficiency of the complex as a light emitting material is also large.
Specific examples of the rings A¹ and A² forming the ligand represented by the general formula (9) include: halogen atoms such as chlorine, bromine, iodine, and fluorine; substituted or unsubstituted alkyl groups such as a methyl group, an ethyl group, a propyl group, a butyl group, an sec-butyl group, a tert-butyl group, a pentyl group, a hexyl group, a heptyl group, an octyl group, a stearyl group, and a trichloromethyl group; substituted or unsubstituted aryl groups such as a phenyl group, a naphthyl group, a 3-methylphenyl group, a 3-methoxyphenyl group, a 3-fluorophenyl group, a 3-trichloromethylphenyl group, a 3-trifluoromethylphenyl group, and a 3-nitrophenyl group; substituted or unsubstituted alkoxy groups such as a methoxy group, an n-butoxy group, a tert-butoxy group, a trichloromethoxy group, a trifluoroethoxy group, a pentafluoropropoxy group, a 2,2,3,3-tetrafluoropropoxy group, a 1,1,1,3,3,3-hexafluoro-2-propoxy group, and a 6-(perfluoroethyl)hexyloxy group; substituted or unsubstituted aryloxy groups such as a phenoxy group, a p-nitrophenoxy group, a p-tert-butylphenoxy group, a 3-fluorophenoxy group, a pentafluorophenyl group, and a 3-trifluoromethylphenoxy group; substituted or unsubstituted alkylthio groups such as a methylthio group, an ethylthio group, a tert-butylthio group, a hexylthio group, an octylthio group, and a trifluoromethylthio group; substituted or unsubstituted arylthio groups such as a phenylthio group, a p-nitrophenylthio group, a ptert-butylphenylthio group, a 3-fluorophenylthio group, a pentafluorophenylthio group, and a 3-trifluoromethylphenylthio group; monosubstituted or disubstituted amino groups such as a cyano group, a nitro group, an amino group, a methylamino group, a diethylamino group, an ethylamino group, a diethylamino group, dipropylamino group, a dibutylamino group, and a diphenylamino group; acylamino groups such as a bis (acetoxymethyl) amino group, a bis (acetoxymethyl) amino group,a bisacetoxypropyl)amino group,andabis(acetoxybutyl)amino group; a hydroxyl group; a siloxy group; an acyl group; carbamoyl groups such as a methylcarbamoyl group, a dimethylcarbamoyl group, an ethylcarbamoyl group, a diethylcarbamoyl group, a propylcarbamoyl group, a butylcarbamoyl group, and a phenylcarbamoyl group; a carboxylic group; a sulfonic group; an imide group; cycloalkyl groups such as a cyclopentane group and a cyclohexyl group; aryl groups such as a phenyl group, a naphthyl group, a biphenyl group, an anthranyl group, a phenanthryl group, a fluorenyl group, and a pyrenyl group; and heterocyclic groups such as a pyridinyl group, a pyradinyl group, a pyrimidinyl group, a pyridadinyl group, a triazinyl group, an indolinyl group, a quinolinyl group, an acrydinyl group, a pyrrolidinyl group, a dioxanyl group, a piperidinyl group, a morpholidinyl group, a piperadinyl group, a triatinyl group, a carbazolyl group, a furanyl group, a thiophenyl group, an oxazolyl group, an oxadiazolyl group, a benzoxazolyl group, a thiazolyl group, a thiadiazolyl group, a benzothiazolyl group, a triazolyl group, an imidazolyl group, a benzoimidazolyl group, and a pranyl group. The above substituents may bond each other to form additional six-membered rings or heterocyclic rings.

Each of the electron injecting layer and the electron transporting layer in the present invention may be constituted of a single layer composed of one or two or more kinds of the above-described materials, or an electron injecting layer or an electron transporting layer composed of another compound may be laminated. The thickness of each of the electron injecting layer and the electron transporting layer is not particularly limited, but is preferably 1 to 100 nm.

In the white color organic EL device of the present invention, a region where an electron is transported or an interfacial region between the cathode and an organic layer may contain a reductive dopant. The term "reductive dopant" as used herein is defined as a substance capable of reducing an electron transportable compound. Therefore, any one of various substances each having certain reducing property can be used. For example, at least one substance selected from the group consisting of an alkali metal, an alkali earth metal, a rare earth metal, an oxide of an alkali metal, a halide of an alkali metal, an oxide of an alkali earth metal, a halide of an alkali earth metal, an oxide of a rare earth metal, a halide of a rare earth metal, an organic complex of an alkali metal, an organic complex of an alkali earth metal, and an organic complex of a rare earth metal can be suitably used.
Specific examples of a preferable reductive dopant include: at least one alkali metal selected from the group consisting of Na (having a work function of 2.36 eV), K (having a work function of 2.28 eV), Rb (having a work function of 2.16 eV), and Cs (having a work function of 1.95 eV); and at least one alkali earth metal selected from the group consisting of Ca (having a work function of 2.9 eV), Sr (having a work function of 2.0 to 2.5 eV), and Ba (having a work function of 2.52 eV). A reductive dopant having a work function of 2.9 eV or less is particularly preferable. The reductive dopant is more preferably at least one alkalimetal selected from the group consisting of K, Rb, and Cs, still more preferably Rb or Cs, or most preferably Cs. Each of those alkali metals has a particularly high reducing ability, so the addition of a relatively small amount of each of them to an electron injection region improves the efficiency of light emission of an organic EL device and prolongs the lifetime of the device. A combination of two or more kinds of alkali metals is also a preferable reductive agent having a work function of 2.9 eV or less. In particular, a combination including Cs such as a combination of Cs and Na, Cs and K, Cs and Rb, or Cs, Na, and K is preferable. A combination with Cs enables a reducing ability to be efficiently exerted. In addition, the addition of such combination to an electron injection region improves the efficiency of light emission of an organic EL device and prolongs the lifetime of the device.

The white color organic EL device of the present invention may further have an electron injecting layer constituted of an insulator or of a semiconductor sandwiched between the cathode and an organic layer. At this time, the leak of a current can be effectively prevented, and electron injection property can be improved. In addition, an inorganic compound for the insulator or the semiconductor is preferably a microcrystalline or amorphous insulating thin film. When an electron transporting layer is constituted of such insulating thin film, image defects such as a dark spot can be reduced because a thin film with improved homogeneity is formed.
At least one metal compound selected from the group consisting of an alkali metal chalcogenide, an alkali earth metal chalcogenide, a halide of an alkali metal, and a halide of an alkali earth metal is preferably used for such insulator. The electron injecting layer is preferably constituted of such alkali metal chalcogenide or the like because electron injection property can be additionally improved. Specific examples of a preferable alkali metal chalcogenide include Li₂O, LiO, Na₂S, Na₂Se, and NaO. Examples of a preferable alkali earth metal chalcogenide include CaO, BaO, SrO, BeO, BaS, and CaSe. Examples of a preferable halide of an alkali metal include LiF, NaF, KF, LiCl, KCl, and NaCl. Examples of a preferable halide of an alkali earth metal include: fluorides such as CaF₂, BaF₂, SrF₂, MgF₂, and BeF₂; and halides except fluorides.
Examples of the semiconductor include: a single kind of oxides, nitrides, oxynitrides, and the like each containing at least one element of Ba, Ca, Sr, Yb, Al, Ga, In, Li, Na, Cd, Mg, Si, Ta, Sb, and Zn; and a combination of two or more of them.

In the white color organic EL device of the present invention, each of the light emitting layer and at least one of the organic layers sandwiched between the light emitting layer and the anode preferably contains an oxidant. An electron-withdrawing oxidant or an electron acceptor is a preferable oxidant. Specific examples of the preferable oxidant include Lewis acids, various quinone derivatives, dicyanoquinodimethane derivatives, and salts formed of aromatic amines and Lewis acids. Examples of the Lewis acids include iron chloride, antimony chloride, and aluminum chloride.
In the white color organic EL device of the present invention, each of the light emitting layer and at least one of the organic layers sandwiched between the light emitting layer and the cathode preferably contains a reductive agent. Examples of a preferable reductive agent include an alkali metal, an alkali earth metal, an alkali metal oxide, an alkali earth oxide, an rare earth oxide, an alkali metal halide, an alkali earth halide, a rare earth halide, and a complex formed of an alkali metal and an aromatic compound. Particularly preferable alkali metals are Cs, Li, Na, and K.

Furthermore, the white color organic EL device of the present invention may have an inorganic compound layer in contact with the anode and/or the cathode. The inorganic compound layer functions as an adhesion improving layer. Examples of a preferable inorganic compound to be used for the inorganic compound layer include: an alkali metal oxide; an alkali earth oxide; a rare earth oxide; an alkali metal halide; an alkali earth halide; a rare earth halide; and various oxides, nitrides, and oxynitrides such as SiOₓ, AlOₓ, SiNₓ, SiON, AlON, GeOₓ, LiOₓ, LiON, TiOₓ, TiON, TaOₓ, TaON, TaNₓ, and C. SiOₓ, AlOₓ, SiNₓ, SiON, AlON, GeOₓ, and C are particularly preferable components for a layer to be in contact with the anode because each of them forms a stable injection interfacial layer. In addition, LiF, MgF₂, CaF₂, MgF₂, and NaF are particularly preferable components for a layer to be in contact with the cathode. The thickness of the inorganic compound layer is not particularly limited, but is preferably 0.1 nm to 100 nm.

A method of forming an organic thin film layer and an inorganic compound layer each including the light emitting layer of the white color organic EL device of the present invention is not particularly limited. For example, any one of conventionally known methods such as a deposition method, a spin coating method, a cast method, and an LB method is applicable. In addition, the electron injecting layer and the light emitting layer are preferably formed by means of the same method because the properties of an organic EL device to be obtained become uniform and the production time for the device can be shortened. For example, when the electron injecting layer is formed by means of a vapor deposition method, the light emitting layer is preferably formed by means of the vapor deposition method.

A metal, alloy, or electroconductive compound having a large work function (for example, 4.0 eV or more), or a mixture of them is preferably used for the anode of the white color organic EL device of the present invention. Specifically, a single kind of indium tin oxide (ITO), indium zinc oxide, tin, zinc oxide, gold, platinum, palladium, and the like can be used, or two or more kinds of them can be used in combination. The thickness of the anode is not particularly limited, but is in the range of preferably 10 to 1,000 nm, or more preferably 10 to 200 nm.
A metal, alloy, or electroconductive compound having a small work function (for example, less than 4.0 eV), or a mixture of them is preferably used for the cathode. Specifically, a single kind of magnesium, aluminum, indium, lithium, sodium, silver, and the like canbe used, or two ormore kinds of them can be used in combination. The thickness of the cathode is not particularly limited either, but is in the range of preferably 10 to 1,000 nm, or more preferably 10 to 200 nm.
In addition, at least one of the anode and the cathode is preferably substantially transparent so that light emitted from the light emitting layer can be effectively taken to the outside. More specifically, at least one of them preferably has a light transmittance of 10% or more. An electrode can be produced by means of, for example, a vacuum vapor deposition method, a sputtering method, an ion plating method, an electron beam vapor deposition method, a CVD method, an MOCVD method, or a plasma CVD method.

### EXAMPLES

Next, the present invention will be described in more detail by way of examples.
Example 1 (Fabrication of white color organic EL device)
A glass substrate equipped with an ITO transparent electrode and measuring 25 mm x 75 mm x 1.1 mm (manufactured by GEOMATEC Co., Ltd.) was subjected to ultrasonic cleaning in isopropyl alcohol for 5 minutes. After that, the substrate was subjected to UV ozone cleaning for 30 minutes. The washed glass substrate equipped with a transparent electrode line was mounted on a substrate holder of a vacuum vapor deposition device. At first, the following compound (HI1) was formed into a film having a thickness of 60 nm (hereinafter, abbreviated as the "HI1 film") on the surface on which the transparent electrode line was formed so as to cover the transparent electrode. The HI1 film functions as a hole injecting layer. Subsequent to the formation of the HI1 film, the following compound (TBDB) was formed into a film having a thickness of 20 nm (hereinafter, abbreviated as the "TBDB film") on the HI1 film. The TBDB film functions as a hole transporting layer. Furthermore, subsequent to the formation of the TBDB film, the above compound (BH1) as an asymmetric compound containing a condensed ring and the following compound (BD1) as a bluish color dopant were deposited from the vapor at a weight ratio of 40 : 2 to form a film having a thickness of 10 nm, and the resultant film was defined as a bluish color light emitting layer. Next, the compound (BH1) and the compound (RD1) as a yellow-to-reddish color dopant were deposited from the vapor at a weight ratio of 40 : 1 to form a film having a thickness of 30 nm, and the resultant film was defined as a yellow-to-reddish color light emitting layer. Tris(8-quinolinol)aluminum was formed into a film having a thickness of 10 nm (hereinafter, abbreviated as the "Alq film") as an electron transporting layer on the layer. After that, 1 nm of LiF was vapor-deposited to serve as an electron injecting layer, and then 150 nm of Al was deposited from the vapor to serve as a cathode. Thus, an organic EL device was fabricated.

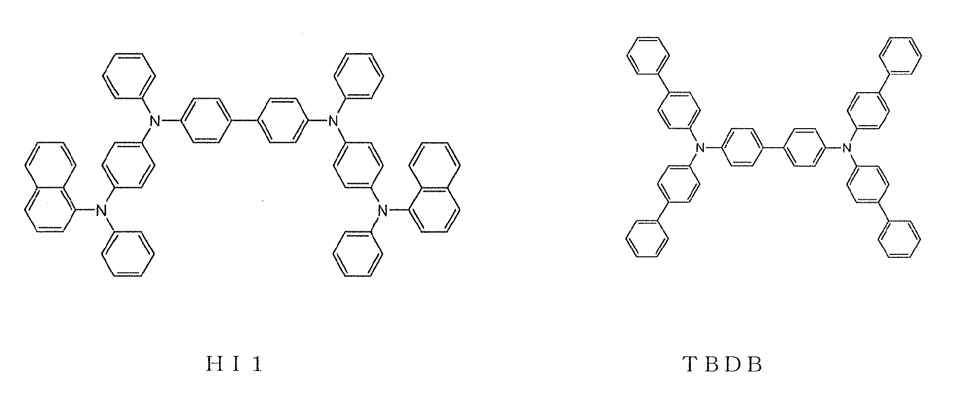

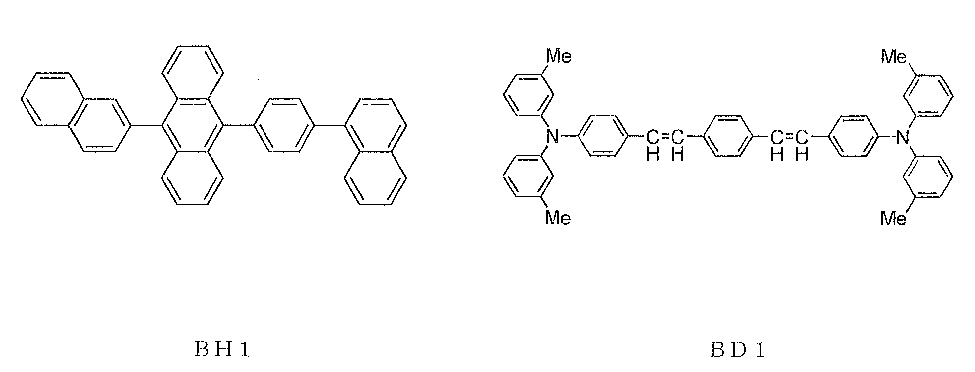

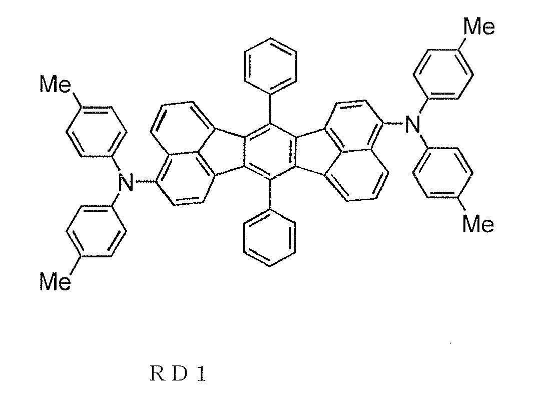

wherein Me represents a methyl group.

The resultant device was subjected to an initial performance test, a half lifetime test, and a thermal stability test. Table 1 shows the results.
Current efficiency (light emission per current density) upon application of a voltage of 5. 5 V and chromaticity coordinates were measured as initial performance.
A spectral luminance radiometer CS-1000 manufactured by MINOLTA was used for measuring the chromaticity coordinates (CIE1931 chromaticity coordinates) and the emission luminance.
A half lifetime was obtained by measuring the time at which the luminance of the device reduced by one-half from the start of the driving of the device with an initial luminance of 1,000 nit at room temperature and a constant current.
The thermal stability test was performed to measure the retention of the luminance and variations in chromaticity coordinates after the driving of the device with an initial luminance of 300 nit at a constant current and 85°C for 500 hours.

### Examples 2 to 7

An organic EL device was fabricated in exactly the same manner as in Example 1 except that the compound (BH2) (Example 2), the compound (BH3) (Example 3), the compound (BH4) (Example 4), the compound (BH5) (Example 5), the compound (BH6) (Example 6), or the compound (BH7) (Example 7) was used as an asymmetric compound containing a condensed ring instead of the compound (BH1), and the resultant device was subjected to an initial performance test, a half lifetime test, and a thermal stability test in the same manner as in Example 1. Table 1 shows the results.

### Examples 8 and 9

An organic EL device was fabricated in exactly the same manner as in Example 1 except that the compound (BH14) (Example 8) or the compound (BH15) (Example 9) was used as an asymmetric compound containing a condensed ring instead of the compound (BH1), and the resultant device was subjected to an initial performance test, a half lifetime test, and a thermal stability test in the same manner as in Example 1. Table 1 shows the results.

### Example 10

An organic EL device was fabricated in exactly the same manner as in Example 1 except that the following compound (BD2) was used as a bluish color dopant instead of the compound (BD1), and the resultant device was subjected to an initial performance test, a half lifetime test, and a thermal stability test in the same manner as in Example 1. Table 1 shows the results.

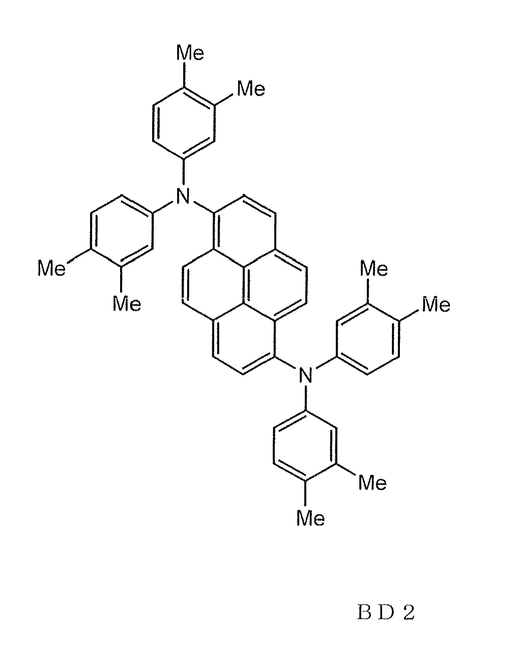

### Comparative Example 1

An organic EL device was fabricated in the same manner as in Example 1 except for the following. Instead of forming the bluish color light emitting layer and the yellow-to-reddish color light emitting layer of Example 1, the following anthracene derivative DPVDPAN and the compound (BD1) as a bluish color dopant were deposited from the vapor at a weight ratio of 40 : 1 to form a film having a thickness of 10 nm, and the resultant film was defined as a bluish color light emitting layer, and then the anthracene derivative DPVDPAN and the compound (rd1) as a reddish color dopant were deposited from the vapor on a TBDB film at a weight ratio of 40 : 1 to form a film having a thickness of 30 nm, and the resultant film was defined as a yellow-to-reddish color light emitting layer. The resultant device was subjected to an initial performance test, a half lifetime test, and a thermal stability test in the same manner as in Example
1. Table 1 shows the results.

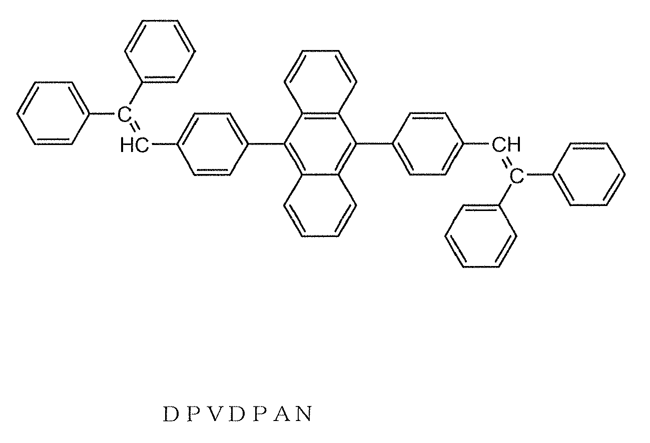

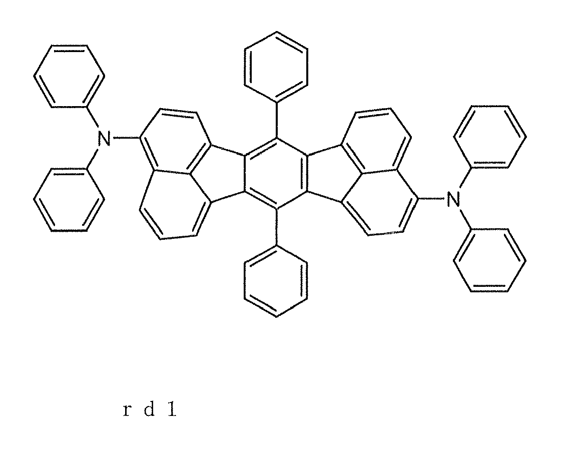

### Comparative Examples 2 to 6

An organic EL device was fabricated in exactly the same manner as in Example 1 except that the following compound (bh1), the following compound (bh2), the following compound (bh3), the following compound (bh4), or the following compound (bh5) was used instead of the compound (BH1), and the resultant device was subjected to an initial performance test, a half lifetime test, and a thermal stability test in the same manner as in Example 1. Table 1 shows the results. 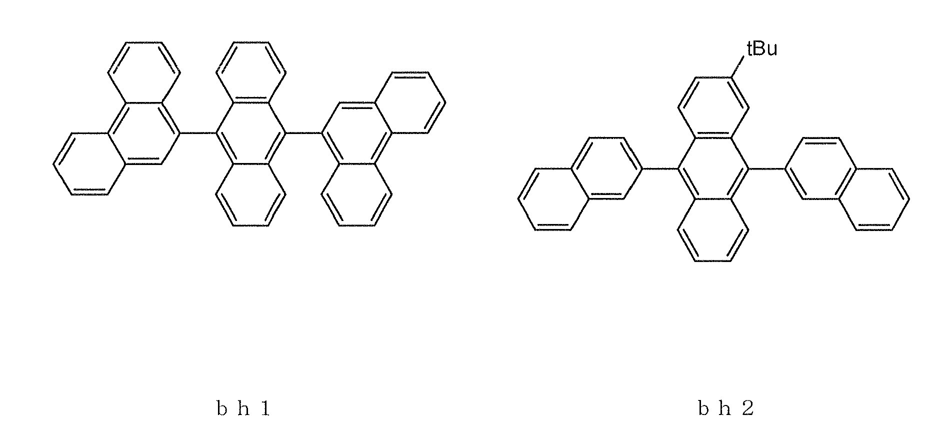 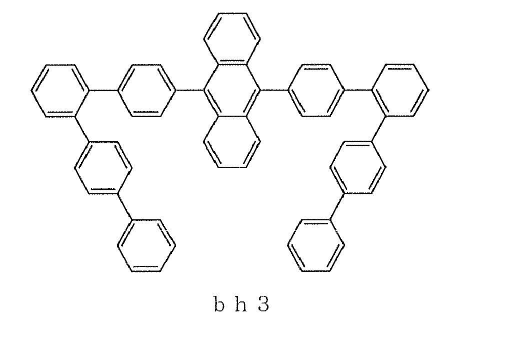 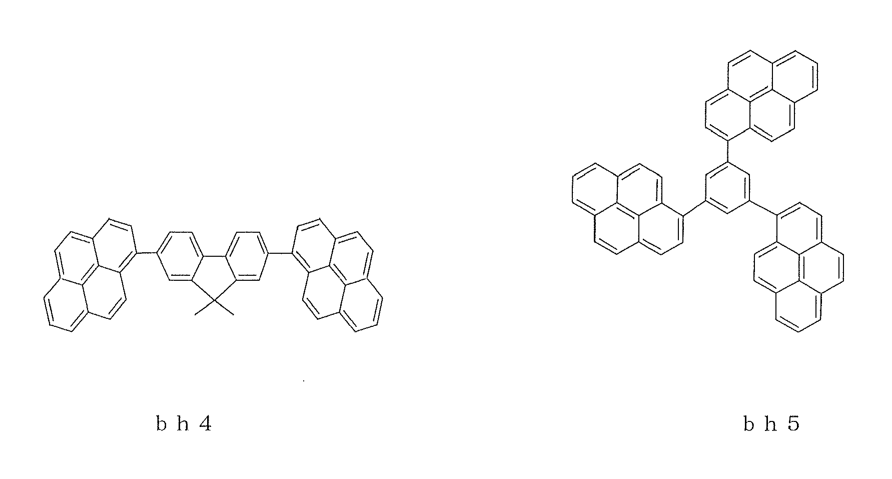 wherein tBu represents a t-butyl group.

**Table 1**

| | Initial performance | | | Thermal stability test (driven at 85°C) | |
|---|---|---|---|---|---|
| | Current Efficiency (cd/A) | Chromaticity coordinates | Half lifetime (hours) | Retention of luminance after 500 hours (%) | Variations in chromaticity coordinates |
| Example 1 | 7.1 | (0.315, 0.364) | 28,000 | 93 | (-0.004, -0.004) |
| Example 2 | 7.0 | (0.316, 0.366) | 32,000 | 95 | (-0.003, -0.004) |
| Example 3 | 7.0 | (0.314, 0.363) | 27,000 | 91 | (-0.004, -0.004) |
| Example 4 | 6.9 | (0.315, 0.367) | 35,000 | 95 | (-0.003, -0.004) |
| Example 5 | 7.2 | (0.317, 0.364) | 29,000 | 94 | (-0.005, -0.004) |
| Example 6 | 7.1 | (0.315, 0.368) | 24,000 | 92 | (-0.003, -0.004) |
| Example 7 | 7.2 | (0.315, 0.367) | 25,000 | 91 | (-0.005, -0.005) |
| Example 8 | 7.0 | (0.315, 0.368) | 26,000 | 91 | (-0.003, -0.004) |
| Example 9 | 7.0 | (0.315, 0.368) | 26,000 | 91 | (-0.003, -0.004) |
| Example 10 | 7.4 | (0.317, 0.366) | 27,000 | 92 | (-0.004, -0.005) |
| Comparative Example 1 | 7.0 | (0.282, 0.280) | 10,000 | 83 | (-0.012, -0.016) |
| Comparative Example 2 | 6.8 | (0.314, 0.362) | 13,000 | 85 | (-0.011, -0.015) |
| Comparative Example 3 | 6.2 | (0.314, 0.363) | 4,000 | 73 | (-0.017, -0.026) |
| Comparative Example 4 | 6.6 | (0.314, 0.360) | 11,000 | 83 | (-0.013, -0.015) |
| Comparative Example 5 | 6.3 | (0.315, 0.367) | 9,500 | 88 | (-0.015, -0.016) |
| Comparative Example 6 | 6.4 | (0.314, 0.370) | 11,000 | 89 | (-0.013, -0.015) |

As shown in Table 1, each of the organic EL devices of Examples 1 to 10 shows small chromaticity changes due to a thermal stability test and has high efficiency of light emission and strikingly prolonged lifetime as compared to those of Comparative Examples 1 to 6.

### INDUSTRIAL APPLICABILITY

As described above in detail, the white color organic EL device of the present invention realizes reduced chromaticity changes, excels in efficiency of light emission and thermal stability, and ensures strikingly prolonged lifetime, so it has high practicability.
Therefore, the device is extremely practical and useful as a full-color display, an information display instrument, an on-vehicle display instrument, or a light source.

## Claims

1. A white color organic electroluminescence device comprising:
a cathode;
an anode; and
one or more organic thin film layers sandwiched between the two electrodes and including at least a light emitting layer,
wherein the light emitting layer has a laminate comprising a bluish color light emitting layer and a yellow-to-reddish color light emitting layer; and
the light emitting layer comprises an asymmetric compound containing a condensed ring.

2. A white color organic electroluminescence device according to claim 1, wherein the light emitting layer consists of the bluish color light emitting layer and the yellow-to-reddish color light emitting layer.

3. A white color organic electroluminescence device according to claim 1, wherein the bluish color light emitting layer comprises a bluish color host material and a bluish color dopant, and the bluish color host material comprises an asymmetric compound containing a condensed ring.

4. A white color organic electroluminescence device according to claim 1, wherein the asymmetric compound containing a condensed ring comprises an asymmetric anthracene-based compound represented by the following general formula (I): 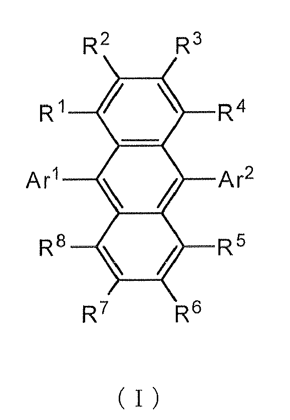 wherein Ar¹ and Ar² each independently represent a substituted or unsubstituted aryl group having 6 to 50 nuclear carbon atoms, provided that Ar¹ and Ar² do not have the same structure; and
R¹ to R⁸ each independently represent a hydrogen atom, a substituted or unsubstituted aryl group having 6 to 50 nuclear carbon atoms, a substituted or unsubstituted aromatic heterocyclic group having 5 to 50 nuclear atoms, a substituted or unsubstituted alkyl group having 1 to 50 carbon atoms, a substituted or unsubstituted alkoxy group having 1 to 50 carbon atoms, a substituted or unsubstituted aralkyl group having 6 to 50 carbon atoms, a substituted or unsubstituted aryloxy group having 5 to 50 nuclear atoms, a substituted or unsubstituted arylthio group having 5 to 50 nuclear atoms, a substituted or unsubstituted alkoxycarbonyl group having 1 to 50 carbon atoms, a carboxyl group, a halogen atom, a cyano group, a nitro group, or a hydroxyl group.

5. A white color organic electroluminescence device according to claim 1, wherein the asymmetric compound containing a condensed ring comprises an asymmetric anthracene-based compound represented by any one of the following general formulae (II) to (IV): 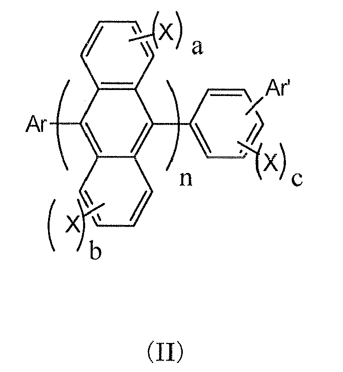 wherein Ar represents a substituted or unsubstituted fused aromatic ring residue having 10 to 50 nuclear carbon atoms;
Ar' represents a substituted or unsubstituted aryl group having 6 to 50 nuclear carbon atoms, and the number of Ar's may be two or more;
**X** represents a substituted or unsubstituted aryl group having 6 to 50 nuclear carbon atoms, a substituted or unsubstituted aromatic heterocyclic group having 5 to 50 nuclear atoms, a substituted or unsubstituted alkyl group having 1 to 50 carbon atoms, a substituted or unsubstituted alkoxy group having 1 to 50 carbon atoms, a substituted or unsubstituted aralkyl group having 6 to 50 carbon atoms, a substituted or unsubstituted aryloxy group having 5 to 50 nuclear atoms, a substituted or unsubstituted arylthio group having 5 to 50 nuclear atoms, a substituted or unsubstituted alkoxycarbonyl group having 1 to 50 carbon atoms, a carboxyl group, a halogen atom, a cyano group, a nitro group, or a hydroxyl group; and
**a**, **b**, and **c** each represent an integer of 0 to 4, and **n** represents an integer of 1 to 3; 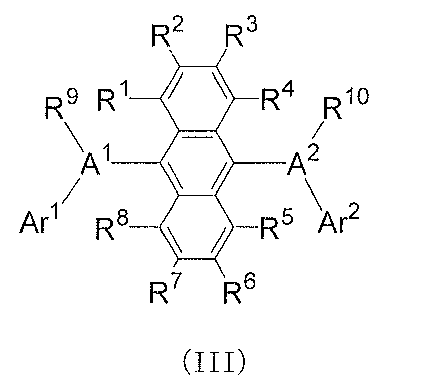 wherein A¹ and A² each independently represent a substituted or unsubstituted fused aromatic ring residue having 10 to 20 nuclear carbon atoms;
Ar¹ and Ar² each independently represent a hydrogen atom, or a substituted or unsubstituted aryl group having 6 to 50 nuclear carbon atoms, and each of the number of Ar¹s and the number of Ar²s may be two or more; and
R¹ to R¹⁰ each independently represent a hydrogen atom, a substituted or unsubstituted aryl group having 6 to 50 nuclear carbon atoms, a substituted or unsubstituted aromatic heterocyclic group having 5 to 50 nuclear atoms, a substituted or unsubstituted alkyl group having 1 to 50 carbon atoms, a substituted or unsubstituted alkoxy group having 1 to 50 carbon atoms, a substituted or unsubstituted aralkyl group having 6 to 50 carbon atoms, a substituted or unsubstituted aryloxy group having 5 to 50 nuclear atoms, a substituted or unsubstituted arylthio group having 5 to 50 nuclear atoms, a substituted or unsubstituted alkoxycarbonyl group having 1 to 50 carbon atoms, a carboxyl group, a halogen atom, a cyano group, a nitro group, or a hydroxyl group, and each of the number of R⁹s and the number of R¹⁰s may be two or more, provided that no symmetrical group binds to each of 9-position and 10-position of central anthracene; 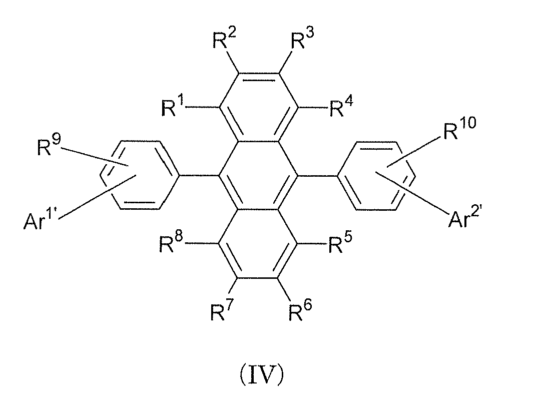 wherein Ar^{1'} and Ar^{2'} each independently represent a substituted or unsubstituted aryl group having 6 to 50 nuclear carbon atoms, and each of the number of Ar¹'s and the number of Ar²'s may be two or more; and
R¹ to R¹⁰ each independently represent a hydrogen atom, a substituted or unsubstituted aryl group having 6 to 50 nuclear carbon atoms, a substituted or unsubstituted aromatic heterocyclic group having 5 to 50 nuclear atoms, a substituted or unsubstituted alkyl group having 1 to 50 carbon atoms, a substituted or unsubstituted alkoxy group having 1 to 50 carbon atoms, a substituted or unsubstituted aralkyl group having 6 to 50 carbon atoms, a substituted or unsubstituted aryloxy group having 5 to 50 nuclear atoms, a substituted or unsubstituted arylthio group having 5 to 50 nuclear atoms, a substituted or unsubstituted alkoxycarbonyl group having 1 to 50 carbon atoms, a carboxyl group, a halogen atom, a cyano group, a nitro group, or a hydroxyl group, and each of the number of R⁹s and the number of R¹⁰s may be two or more, provided that no symmetrical group binds to each of 9-position and 10-position of central anthracene.

6. A white color organic electroluminescence device according to claim 1, wherein the asymmetric compound containing a condensed ring comprises an asymmetric pyrene-based compound represented by the following general formula (V): 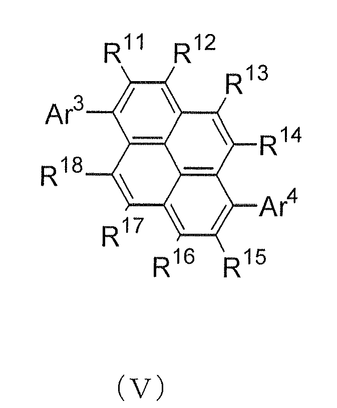 wherein Ar³ and Ar⁴ each independently represent a substituted or unsubstituted aryl group having 6 to 50 nuclear carbon atoms, provided that Ar³ and Ar⁴ do not have the same structure; and
R¹¹ to R¹⁸ each independently represent a hydrogen atom, a substituted or unsubstituted aryl group having 6 to 50 nuclear carbon atoms, a substituted or unsubstituted aromatic heterocyclic group having 5 to 50 nuclear atoms, a substituted or unsubstituted alkyl group having 1 to 50 carbon atoms, a substituted or unsubstituted alkoxy group having 1 to 50 carbon atoms, a substituted or unsubstituted aralkyl group having 6 to 50 carbon atoms, a substituted or unsubstituted aryloxy group having 5 to 50 nuclear atoms, a substituted or unsubstituted arylthio group having 5 to 50 nuclear atoms, a substituted or unsubstituted alkoxycarbonyl group having 1 to 50 carbon atoms, a carboxyl group, a halogen atom, a cyano group, a nitro group, or a hydroxyl group.

7. A white color organic electroluminescence device according to claim 1, wherein the asymmetric compound containing a condensed ring comprises an asymmetric pyrene-based compound represented by any one of the following general formulae (VI) to (IX): 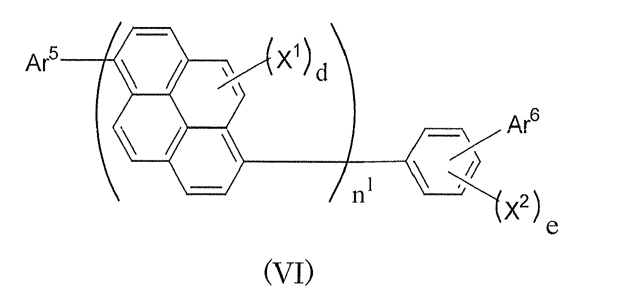 wherein Ar⁵ represents a substituted or unsubstituted fused aromatic ring residue having 10 to 50 nuclear carbon atoms;
Ar⁶ represents a substituted or unsubstituted aryl group having 6 to 50 nuclear carbon atoms, and the number of Ar⁶s may be two or more;
X¹ and X² each independently represent a substituted or unsubstituted aryl group having 6 to 50 nuclear carbon atoms, a substituted or unsubstituted aromatic heterocyclic group having 5 to 50 nuclear atoms, a substituted or unsubstituted alkyl group having 1 to 50 carbon atoms, a substituted or unsubstituted alkoxy group having 1 to 50 carbon atoms, a substituted or unsubstituted aralkyl group having 6 to 50 carbon atoms, a substituted or unsubstituted aryloxy group having 5 to 50 nuclear atoms, a substituted or unsubstituted arylthio group having 5 to 50 nuclear atoms, a substituted or unsubstituted alkoxycarbonyl group having 1 to 50 carbon atoms, a carboxyl group, a halogen atom, a cyano group, a nitro group, or a hydroxyl group; and
**d** represents an integer of 0 to 8, **e** represents an integer of 0 to 4, and n¹ represents an integer of 1 to 3; 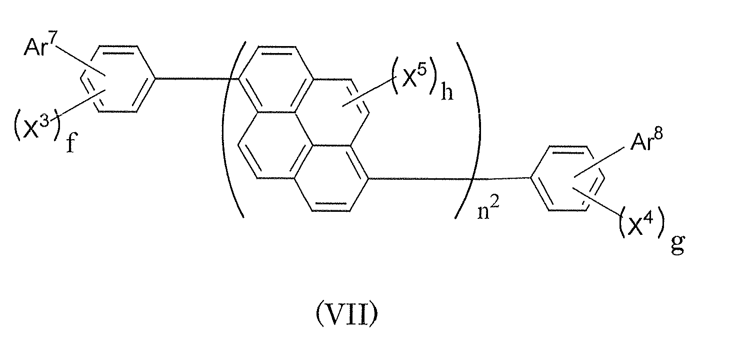 wherein Ar⁷ and Ar⁸ each independently represent a substituted or unsubstituted aryl group having 6 to 50 nuclear carbon atoms, and each of the number of Ar⁷s and the number of Ar⁸s may be two or more; X³, X⁴, and X⁵ each independently represent a substituted or unsubstituted aryl group having 6 to 50 nuclear carbon atoms, a substituted or unsubstituted aromatic heterocyclic group having 5 to 50 nuclear atoms, a substituted or unsubstituted alkyl group having 1 to 50 carbon atoms, a substituted or unsubstituted alkoxy group having 1 to 50 carbon atoms, a substituted or unsubstituted aralkyl group having 6 to 50 carbon atoms, a substituted or unsubstituted aryloxy group having 5 to 50 nuclear atoms, a substituted or unsubstituted arylthio group having 5 to 50 nuclear atoms, a substituted or unsubstituted alkoxycarbonyl group having 1 to 50 carbon atoms, a carboxyl group, a halogen atom, a cyano group, a nitro group, or a hydroxyl group; and
**f** and **g** each represent an integer of 0 to 4, **h** represents an integer of 0 to 8, and n² represents an integer of 1 to 3, provided that no symmetrical group binds to each of 1-position and 6-position of central pyrene; 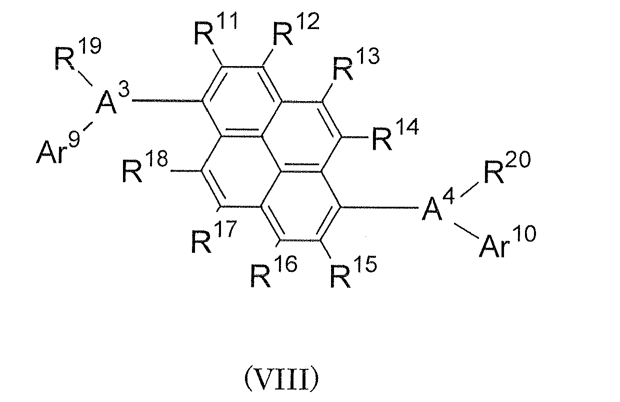 wherein A³ and A⁴ each independently represent a substituted or unsubstituted fused aromatic ring residue having 10 to 20 nuclear carbon atoms;
Ar⁹ and Ar¹⁰ each independently represent a hydrogen atom, or a substituted or unsubstituted aryl group having 6 to 50 nuclear carbon atoms, and each of the number of Ar⁹s and the number of Ar¹⁰s may be two or more; and
R¹¹ to R²⁰ each independently represent a hydrogen atom, a substituted or unsubstituted aryl group having 6 to 50 nuclear carbon atoms, a substituted or unsubstituted aromatic heterocyclic group having 5 to 50 nuclear atoms, a substituted or unsubstituted alkyl group having 1 to 50 carbon atoms, a substituted or unsubstituted alkoxy group having 1 to 50 carbon atoms, a substituted or unsubstituted aralkyl group having 6 to 50 carbon atoms, a substituted or unsubstituted aryloxy group having 5 to 50 nuclear atoms, a substituted or unsubstituted arylthio group having 5 to 50 nuclear atoms, a substituted or unsubstituted alkoxycarbonyl group having 1 to 50 carbon atoms, a carboxyl group, a halogen atom, a cyano group, a nitro group, or a hydroxyl group, and each of the number of R¹⁹s and the number of R²⁰s may be two or more, provided that no symmetrical group binds to each of 1-position and 6-position of central pyrene; 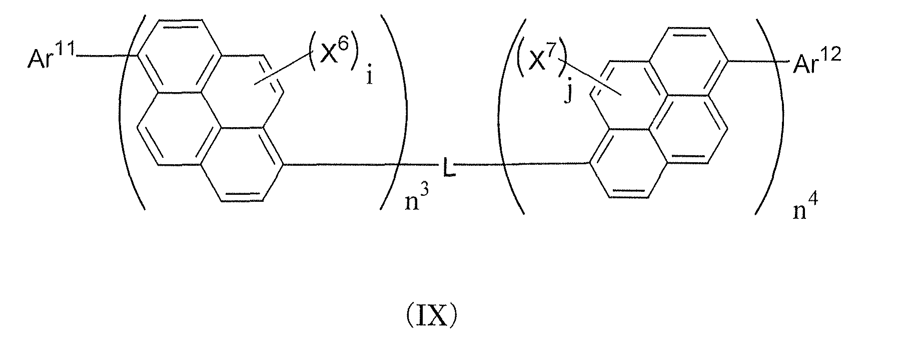 wherein Ar¹¹ and Ar¹² each independently represent a substituted or unsubstituted aryl group having 6 to 50 nuclear carbon atoms;
X⁶ and X⁷ each independently represent a substituted or unsubstituted aryl group having 6 to 50 nuclear carbon atoms, a substituted or unsubstituted aromatic heterocyclic group having 5 to 50 nuclear atoms, a substituted or unsubstituted alkyl group having 1 to 50 carbon atoms, a substituted or unsubstituted alkoxy group having 1 to 50 carbon atoms, a substituted or unsubstituted aralkyl group having 6 to 50 carbon atoms, a substituted or unsubstituted aryloxy group having 5 to 50 nuclear atoms, a substituted or unsubstituted arylthio group having 5 to 50 nuclear atoms, a substituted or unsubstituted alkoxycarbonyl group having 1 to 50 carbon atoms, a carboxyl group, a halogen atom, a cyano group, a nitro group, or a hydroxyl group;
**L** represents a substituted or unsubstituted arylene group having 6 to 50 nuclear carbon atoms, or a substituted or unsubstituted divalent aromatic heterocyclic group having 3 to 50 nuclear atoms; and
**i** and **j** each represent an integer of 0 to 8, and n³ and n⁴ each represent an integer of 1 to 3

8. A white color organic electroluminescence device according to claim 3, wherein the bluish color dopant comprises at least one compound selected from a group consisting of a styrylamine, an amine-substituted styryl compound, a compound containing an amine-substituted fused aromatic ring, and a compound containing a fused aromatic ring.

9. A white color organic electroluminescence device according to claim 1, comprising the anode, the bluish color light emitting layer, the yellow-to-reddish color light emitting layer, and the cathode in this order, wherein the yellow-to-reddish color light emitting layer contains the same host material as that of the bluish color light emitting layer and a yellow-to-reddish color dopant.

10. A white color organic electroluminescence device according to claim 9, wherein the yellow-to-reddish color dopant comprises a compound having multiple fluoranthene skeletons.

11. A white color organic electroluminescence device according to claim 9, wherein the yellow-to-reddish color dopant comprises a compound having a fluorescent peak wavelength of 540 nm to 700 nm.

12. A white color organic electroluminescence device according to claim 1, wherein each of the bluish color light emitting layer and the yellow-to-reddish color light emitting layer has a thickness of 5 nm or more.
